# EUROPEAN PATENT APPLICATION

(11) **EP 3 917 290 A1**
(43) Date of publication of application: **01.12.2021**
(21) Application number: 21175194.6
(22) Date of filing: 21.05.2021
(51) Int. Cl.: H05K 1/02, H05K 1/09, H05K 1/16, H05K 3/12, H05K 3/40

(54) **RESIN COMPOSITION**

(30) Priority: 26.05.2020 JP 2020091681
(71) Applicant: AJINOMOTO CO., INC., Chuo-ku Tokyo 104-8315 (JP)
(72) Inventor: OURA, Ichiro, Kanagawa, 210-0801 (JP); OOYAMA, Hideki, Kanagawa, 210-0801 (JP)
(74) Representative: Mewburn Ellis LLP

(57) **Abstract**

Provided is a resin composition including (A) a magnetic powder and (B) a thermosetting resin, in which the (A) component includes (A-1) a ferrite powder having an average particle diameter of 0.8 pm or less and (A-2) a magnetic powder having an average particle diameter of 1.5 pm or more; and a volume ratio of the (A-2) component to the (A-1) component ((A-2) component/(A-1) component) is in the range of 0.8 to 34.0.

## Description

### BACKGROUND OF THE INVENTION

### Field of the invention

The present invention relates to a resin composition containing magnetic powder. The present invention further relates to a cured product, a resin sheet, a circuit substrate, and an inductor substrate, all of which are obtained by using this resin composition.

### Description of the Related Art

Many of inductor elements are equipped to the information terminal of a mobile phone, a smart phone, and the like. Conventionally, an independent inductor part has been mounted on a substrate; but, in recent years, a method is being used in which a coil is formed by the conductive pattern of the substrate thereby forming an inductor element inside the substrate. Known examples of the method to form the inductor element inside the substrate include the method in which a magnetic material containing magnetic powder is screen-printed on a substrate having a wiring to form a cured product thereof (Japanese Patent Application Laid-open No. H06-69058 and Japanese Patent Application Laid-open No. 2017-63100). In recent years, in order to further improve performance of the inductor element, further improvement of the magnetic characteristics of the magnetic material is required. To improve the magnetic characteristics of the magnetic material, the method to increase the content of the magnetic powder in the material may be conceived. Known examples of the magnetic material having the enhanced magnetic characteristics include the one that uses two or more kinds of magnetic metal powders having different particle diameters thereby increasing the filling rate of the powders (Japanese Patent Application Laid-open No. 2019-220609).

The prior art documents are as follows. Japanese Patent Application Laid-open No. H06-69058 Japanese Patent Application Laid-open No. 2017-63100 Japanese Patent Application Laid-open No. 2019-220609

### SUMMARY OF THE INVENTION

However, there is a limit in improvement of the relative permeability by increasing the filling rate, and in addition, the higher filling rate tends to impair a mechanical strength of the magnetic material thereby easily causing problems such as cracks, thereby leading in turn to lower the production stability of the inductor element.

An object of the present invention is to provide a resin composition capable of giving a magnetic material (cured product) that is superior in the mechanical strength as well as the relative permeability.

The inventor of the present invention carried out an extensive investigation to achieve the object mentioned above; then, following results were obtained. Namely, in the thermosetting resin composition containing two kinds of magnetic powders, one having an average particle diameter of 0.8 µm or less and another having an average particle diameter of 1.5 µm or more, when a ferrite powder is used as the magnetic powder having the average particle diameter of 0.8 µm or less with a prescribed ratio, surprisingly, the superior relative permeability could be obtained while keeping the mechanical strength of the composition. The present invention was accomplished on the basis of this finding.

Therefore, the present invention includes follows.
[1] A resin composition including:
   (A) a magnetic powder; and
   (B) a thermosetting resin,
   in which
   the (A) component includes (A-1) a ferrite powder having an average particle diameter of 0.8 µm or less and (A-2) a magnetic powder having an average particle diameter of 1.5 µm or more, and
   a volume ratio of the (A-2) component to the (A-1) component ((A-2) component/(A-1) component) is in a range of 0.8 to 34.0.
[2] The resin composition according to above [1], wherein the average particle diameter of the (A-2) component is 10.0 µm or less.
[3] The resin composition according to above [1] or [2], wherein the average particle diameter of the (A-2) component is 2.5 µm or more.
[4] The resin composition according to any of above [1] to [3], wherein the average particle diameter of the (A-1) component is 0.1 µm or more.
[5] The resin composition according to any of above [1] to [4], wherein the average particle diameter of the (A-1) component is 0.3 µm or less.
[6] The resin composition according to any of above [1] to [5], wherein a ratio of the average particle diameter of the (A-2) component to the average particle diameter of the (A-1) component ((A-2) component/(A-1) component) is 10 or more.
[7] The resin composition according to any of above [1] to [6], wherein the (A-1) component includes a ferrite powder including, in addition to Fe, at least one element selected from Mn, Zn, Mg, Sr, and Ni.
[8] The resin composition according to any of above [1] to [7], wherein the (A-2) component includes a magnetic alloy powder.
[9] The resin composition according to any of above [1] to [8], wherein a content of the (A) component is, based on 100% by volume of non-volatile components in the resin composition, 50% or more by volume.
[10] The resin composition according to any of above [1] to [9], wherein a content of the (A) component is, based on 100% by volume of non-volatile components in the resin composition, 80% or less by volume.
[11] The resin composition according to any of above [1] to [10], wherein a volume ratio of the (A-2) component to the (A-1) component ((A-2) component/(A-1) component) is 20.0 or less.
[12] The resin composition according to above [11], wherein a volume ratio of the (A-2) component to the (A-1) component ((A-2) component/(A-1) component) is 10.0 or less.
[13] The resin composition according to any of above [1] to [12], wherein the (B) component includes (B-1) an epoxy resin.
[14] The resin composition according to any of above [1] to [13], wherein a tensile strength at a breaking point of a cured product of the resin composition measured in accordance with JIS K7127 is 60 MPa or more.
[15] The resin composition according to any of above [1] to [14], wherein a relative permeability (µ') of a cured product of the resin composition measured at 23°C with a measurement frequency of 100 MHz is 10.0 or more.
[16] A cured product of the resin composition according to any of above [1] to [15].
[17] A resin sheet including:
   a support; and
   a resin composition layer formed on the support and formed of the resin composition according to any of above [1] to [15].
[18] A circuit substrate including:
   a substrate having a through hole; and
   a cured product of the resin composition according to any of above [1] to [15], the through hole being filled with the resin composition.
[19] A circuit substrate including a cured product layer that is a cured product of the resin composition according to any of above [1] to [15].
[20] An inductor substrate including the circuit substrate according to above [18] or [19].

According to the resin composition of the present invention, the magnetic material (cured product) that is superior in the mechanical strength as well as the relative permeability can be obtained.

### BRIEF DESCRIPTION OF THE DRAWINGS

Fig. 1 is a schematic sectional view of the core substrate, as one example of the production method of a circuit substrate according to a first embodiment;
Fig. 2 is a schematic sectional view of the core substrate having a through hole formed therein, as one example of the production method of a circuit substrate according to the first embodiment;
Fig. 3 is a schematic sectional view illustrating the core substrate having a plated layer in the through hole, as one example of the production method of a circuit substrate according to the first embodiment;
Fig. 4 is a schematic sectional view illustrating the core substrate having a resin composition filled in the through hole, as one example of the production method of a circuit substrate according to the first embodiment;
Fig. 5 is a schematic sectional view illustrating the core substrate having the filled resin composition thermally cured, as one example of the production method of a circuit substrate according to the first embodiment;
Fig. 6 is a schematic sectional view illustrating the core substrate after a cured product is polished, as one example of the production method of a circuit substrate according to the first embodiment;
Fig. 7 is a schematic sectional view illustrating the core substrate having a conductive layer formed on a polished surface, as one example of the production method of a circuit substrate according to the first embodiment;
Fig. 8 is a schematic sectional view illustrating the core substrate having a patterned conductive layer formed, as one example of the production method of a circuit substrate according to the first embodiment;
Fig. 9 is a schematic sectional view to explain the process (A) included in one example of the production method of a circuit substrate according to a second embodiment;
Fig. 10 is a schematic sectional view to explain the process (A) included in one example of the production method of a circuit substrate according to the second embodiment;
Fig. 11 is a schematic sectional view to explain the process (B) included in one example of the production method of a circuit substrate according to the second embodiment;
Fig. 12 is a schematic sectional view to explain the process (D) included in one example of the production method of a circuit substrate according to the second embodiment;
Fig. 13 is a schematic plane view observed from one direction in thickness directions of the inductor part that includes the circuit substrate obtained by one example of the production method of a circuit substrate according to the second embodiment;
Fig. 14 is a schematic plane view illustrating a cut edge face of the inductor part that is cut at the place indicated by the II-II one dot chain line as illustrated in Fig. 13; the inductor part including the circuit substrate obtained by one example of the production method of a circuit substrate according to the second embodiment; and
Fig. 15 is a schematic plane view to explain a composition of the first conductive layer in the inductor part that includes the circuit substrate obtained as one example of the production method of a circuit substrate according to the second embodiment.

### DETAILED DESCRIPTION OF THE PREFERRED EMBODIMENTS

Hereinafter, the present invention will be explained in detail in line with the preferred embodiments thereof. Here, it must be noted that the present invention is not limited to the embodiments and examples described below so that the present invention may be carried out with any arbitrary modification so far as such modification is not outside the claims or the equivalent of the present invention.

### Resin Composition

The resin composition according to the present invention includes (A) a magnetic powder and (B) a thermosetting resin, in which (A) the magnetic powder includes (A-1) a ferrite powder having an average particle diameter of 0.8 µm or less and (A-2) a magnetic powder having an average particle diameter of 1.5 µm or more; and a volume ratio of the magnetic powder of the (A-2) component to the ferrite powder of the (A-1) component ((A-2) component/(A-1) component) is in the range of 0.8 to 34.0. When the resin composition like this is used, the magnetic material (cured product) that is superior in the mechanical strength and the relative permeability can be obtained.

The resin composition according to the present invention may further include an arbitrary component, in addition to (A) the magnetic powder and (B) the thermosetting resin. Illustrative examples of the arbitrary component include (C) other additive and (D) an organic solvent. Hereinafter, these components included in the resin composition will be explained in detail.

### (A) Magnetic Powder

The resin composition according to the present invention includes (A) a magnetic powder. (A) The magnetic powder provides the resin composition with a magnetic property. In the resin composition according to the present invention, (A) the magnetic powder includes (A-1) a ferrite powder having an average particle diameter of 0.8 µm or less and (A-2) a magnetic powder having an average particle diameter of 1.5 µm or more.

### (A-1) Ferrite Powder Having Average Particle Diameter of 0.8 µm or Less

In the resin composition according to the present invention, (A) the magnetic powder includes (A-1) the ferrite powder having an average particle diameter of 0.8 µm or less. The ferrite powder is the magnetic powder formed of a composite oxide mainly composed of an iron oxide. One kind of the ferrite powder of the (A-1) component may be used, or two or more kinds thereof may be used concurrently. It has been known that the ferrite powder is chemically stable, has high corrosion resistance, is low in the risk of ignition, and is resistive to magnetic loss; in addition, this is generally cheap so that the acquisition cost is low.

The ferrite powder of the (A-1) component may be any of a hard ferrite powder and a soft ferrite powder. In one embodiment, from a viewpoint to clearly obtain the effects of the present invention, the soft ferrite powder is preferable. The ferrite powder of the (A-1) component may be any of a spinel ferrite powder, a hexagonal ferrite powder, and a garnet ferrite powder. In one embodiment, from a viewpoint to clearly obtain the effects of the present invention, the spinel ferrite powder is preferable.

The ferrite powder of the (A-1) component may include, in addition to Fe, at least one element selected from, for example, Mn, Zn, Mg, Sr, Ni, Cu, Ba, Co, Ca, Al, Li, Ti, Pb, and Cd. In one embodiment, preferably, the ferrite powder of the (A-1) component includes a ferrite powder including, in addition to Fe, at least one element selected from Mn, Zn, Mg, Sr, and Ni.

Illustrative examples of the ferrite powder of the (A-1) component include: an Fe-Mn type ferrite powder, a Mg-Zn type ferrite powder, a Mn type ferrite powder, a Mn-Zn type ferrite powder, a Mn-Mg type ferrite powder, a Cu-Zn type ferrite powder, a Mg-Sr type ferrite powder, a Mn-Mg-Sr type ferrite powder, a Ni-Zn type ferrite powder, a Ni-Zn-Cu type ferrite powder, a Ba-Zn type ferrite powder, a Ba-Mg type ferrite powder, a Ba-Ni type ferrite powder, a Ba-Co type ferrite powder, a Ba-Ni-Co type ferrite powder, and a Y type ferrite powder. Preferably, the ferrite powder of the (A-1) component includes the ferrite powder selected from the Mn type ferrite powder, the Mn-Zn type ferrite powder, the Mg-Sr type ferrite powder, the Mn-Mg-Sr type ferrite powder, and the Ni-Zn type ferrite powder.

Preferably, the ferrite powder of the (A-1) component is the particle of a quasi-spherical shape or the particle of a quasi-oval shape. The ratio of the long axis (b) to the short axis (a) of the particle of the ferrite powder of the (A-1) component (b/a: aspect ratio) is preferably 2 or less, and more preferably 1.5 or less, while still more preferably 1.2 or less.

The average particle diameter of the ferrite powder of the (A-1) component is 0.8 µm or less. From a viewpoint to obtain the effects of the present invention more clearly, the average particle diameter thereof is preferably 0.6 µm or less, more preferably 0.4 µm or less, and still more preferably 0.3 µm or less, while especially preferably 0.2 µm or less. Although the lower limit of the average particle diameter of the ferrite powder of the (A-1) component is not particularly restricted, it is preferably 0.01 µm or more, more preferably 0.05 µm or more, still more preferably 0.1 µm or more, and especially preferably 0.12 µm or more. In one embodiment, the average particle diameter of the ferrite powder of the (A-1) component is preferably in the range of 0.01 to 0.6 µm, more preferably in the range of 0.05 to 0.4 µm, and still more preferably in the range of 0.1 to 0.3 µm, while especially preferably in the range of 0.12 to 0.2 µm. The average particle diameter of the ferrite powder of the (A-1) component may be a median diameter based on a volume standard. This average particle diameter may be measured with a laser diffraction scattering method based on the Mie scattering theory. Specifically, the particle diameter distribution thereof is prepared on the basis of a volume standard by using a laser diffraction scattering type particle diameter distribution measurement instrument, in which a median diameter thereof may be measured as the average particle diameter thereof. The powders that are dispersed in water by means of an ultrasonic wave may be preferably used as the measurement sample. Illustrative examples of the laser diffraction scattering type particle diameter distribution measurement instrument include "LA-500" manufactured by Horiba Ltd. and "SALD-2200" manufactured by Shimadzu Corp.

The true specific gravity of the ferrite powder of the (A-1) component may be, for example, in the range of 4.7 to 5.2 g/cm³.

The ferrite powder of the (A-1) component that is commercially available may be used as it is, or two or more kinds of them may be concurrently used. Specifically, illustrative examples of the ferrite powder of the (A-1) component that is commercially available include "M001", "MZ001", "E001", and "NZ001" manufactured by Powdertech Co., Ltd.

From a viewpoint to obtain the effects of the present invention more clearly, the content (% by volume) of the ferrite powder of the (A-1) component is, on the basis of 100% by volume of the non-volatile components in the resin composition, preferably 0.5% or more by volume, or 1% or more by volume, while more preferably 2% or more by volume, or 3% or more by volume; and from a viewpoint to further improve a strength at a breaking point, still more preferably 5% or more by volume, or 10% or more by volume, while especially preferably 15% or more by volume, or 20% or more by volume. From a viewpoint to obtain the effects of the present invention more clearly, the upper limit thereof is, on the basis of 100% by volume of the non-volatile components in the resin composition, preferably 50% or less by volume, or 45% or less by volume, while more preferably 40% or less by volume, or 35% or less by volume; and from a viewpoint to further improve the permeability, still more preferably 30% or less by volume, while especially preferably 27% or less by volume. In one embodiment, the content (% by volume) of the ferrite powder of the (A-1) component is, on the basis of 100% by volume of the non-volatile components in the resin composition, preferably in the range of 0.5 to 50% by volume, more preferably in the range of 1 to 45% by volume, and still more preferably in the range of 2 to 40% by volume, while especially preferably in the range of 3 to 35% by volume.

From a viewpoint to obtain the effects of the present invention more clearly, the content (% by mass) of the ferrite powder of the (A-1) component is, on the basis of 100% by mass of the non-volatile components in the resin composition, preferably 0.5% or more by mass, or 1% or more by mass, while more preferably 2% or more by mass, or 3% or more by mass; and from a viewpoint to further improve a strength at a breaking point, still more preferably 5% or more by mass, 10% or more by mass, or 15% or more by mass, while especially preferably 20% or more by mass, or 25% or more by mass. From a viewpoint to obtain the effects of the present invention more clearly, the upper limit thereof is, on the basis of 100% by mass of the non-volatile components in the resin composition, preferably 70% or less by mass, or 60% or less by mass, while more preferably 50% or less by mass, or 40% or less by mass; and from a viewpoint to further improve the permeability, still more preferably 35% or less by mass, while especially preferably 30% or less by mass. In one embodiment, the content (% by mass) of the ferrite powder of the (A-1) component is, on the basis of 100% by mass of the non-volatile components in the resin composition, preferably in the range of 0.5 to 70% by mass, more preferably in the range of 1 to 60% by mass, and still more preferably in the range of 2 to 50% by mass, while especially preferably in the range of 3 to 40% by mass.

### (A-2) Magnetic Powder Having Average Particle Diameter of 1.5 µm or More

In the resin composition according to the present invention, (A) the magnetic powder includes (A-2) the magnetic powder having an average particle diameter of 1.5 µm or more. The magnetic powder of the (A-2) is not particularly restricted; heretofore known magnetic powders may be widely used. One kind of the magnetic powder of the (A-2) component may be used, or two or more kinds thereof may be used concurrently.

The magnetic powder of the (A-2) component may be any of a soft magnetic powder and a hard magnetic powder. In one embodiment, from a viewpoint to clearly obtain the effects of the present invention, a soft magnetic particle is preferable. Illustrative examples of the magnetic powder of the (A-2) component may include a magnetic metal oxide powder and a magnetic metal powder.

The magnetic metal oxide powder is not particularly restricted. Illustrative examples thereof include: ferrite powders such as an Fe-Mn type ferrite powder, a Mg-Zn type ferrite powder, a Mn type ferrite powder, a Mn-Zn type ferrite powder, a Mn-Mg type ferrite powder, a Cu-Zn type ferrite powder, a Mg-Sr type ferrite powder, a Mn-Mg-Sr type ferrite powder, a Ni-Zn type ferrite powder, a Ni-Zn-Cu type ferrite powder, a Ba-Zn type ferrite powder, a Ba-Mg type ferrite powder, a Ba-Ni type ferrite powder, a Ba-Co type ferrite powder, a Ba-Ni-Co type ferrite powder, and a Y type ferrite powder; and iron oxide powders such as an iron (III) oxide powder and a triiron tetraoxide powder.

The magnetic metal powder is not particularly restricted. Illustrative examples thereof include pure iron power; and crystalline or amorphous magnetic alloy powders such as an Fe-Si type alloy powder, an Fe-Si-Al type alloy powder, an Fe-Cr type alloy powder, an Fe-Si-Cr type alloy powder, an Fe-Ni-Cr type alloy powder, an Fe-Cr-Al type alloy powder, an Fe-Ni type alloy powder, an Fe-Ni-Mo type alloy powder, an Fe-Ni-Mo-Cu type alloy powder, an Fe-Co type alloy powder, an Fe-Ni-Co type alloy powder, and a Co-based amorphous alloy powder.

Preferably, the magnetic powder of the (A-2) component includes at least one kind of the magnetic powder selected from the ferrite powders and the magnetic alloy powders. From a viewpoint to improve the permeability furthermore, preferably the magnetic powder includes at least one kind of the magnetic alloy powder, while especially preferably at least one kind of the magnetic alloy powder selected from the Fe-Si-Cr type alloy powder and the Fe-Ni type alloy powder.

Preferably, the magnetic powder of the (A-2) component is the particle of a quasi-spherical shape or the particle of a quasi-oval shape. The ratio of the long axis (b) to the short axis (a) of the particle of the magnetic powder of the (A-2) component (b/a: aspect ratio) is preferably 4 or less, and more preferably 3 or less, while still more preferably 2 or less.

The average particle diameter of the magnetic powder of the (A-2) component is 1.5 µm or more. From a viewpoint to obtain the effects of the present invention more clearly, the average particle diameter may be preferably 2.0 µm or more, more preferably 2.5 µm or more, and still more preferably 2.7 µm or more, while especially preferably 2.8 µm or more. The upper limit of the average particle diameter of the magnetic powder of the (A-2) component is not particularly restricted. From a viewpoint to further suppress the magnetic loss, the upper limit is preferably 10.0 µm or less, more preferably 7.0 µm or less, and still more preferably 5.0 µm or less, while especially preferably 3.5 µm or less. In one embodiment, the average particle diameter of the magnetic powder of the (A-2) component is preferably in the range of 2.0 to 10.0 µm, more preferably in the range of 2.5 to 7.0 µm, and still more preferably in the range of 2.7 to 5.0 µm, while especially preferably in the range of 2.8 to 3.5 µm. The average particle diameter of the magnetic powder of the (A-2) component may be a median diameter on the basis of a volume standard. The average particle diameter of the magnetic powder of the (A-2) component may be measured by the same method as the measurement method of the average particle diameter of the ferrite powder of the (A-1) component.

The ratio of the average particle diameter of the magnetic powder of the (A-2) component to the average particle diameter of the ferrite powder of the (A-1) component (((A-2) component/(A-1) component) is, from a viewpoint to obtain the effects of the present invention more clearly, preferably 10 or more, while more preferably 15 or more. Also, the ratio is preferably 50 or less, while more preferably 30 or less. In one embodiment, also, the ratio is preferably in the range of 10 to 50, while more preferably in the range of 15 to 30.

Although the specific surface area of the magnetic powder of the (A-2) component is not particularly restricted, it is preferably 0.05 m²/g or more, and more preferably 0.1 m²/g or more, while still more preferably 0.3 m²/g or more. Also, it is preferably 30 m²/g or less, and more preferably 20 m²/g or less, while still more preferably 15 m²/g or less. In one embodiment, also, it is preferably in the range of 0.05 to 30 m²/g, and more preferably in the range of 0.1 to 20 m²/g, while still more preferably in the range of 0.3 to 15 m²/g. The specific surface area of (A) the magnetic powder may be measured by the BET method.

The true specific gravity of the magnetic powder of the (A-2) component may be, for example, in the range of 4 to 10 g/cm³.

A commercially available magnetic powder may be used as the magnetic powder of the (A-2) component. Specifically, illustrative examples of the usable magnetic powder that is commercially available include "MZ05" manufactured by Powdertech Co., Ltd. and "AW08PF3F" manufactured by Epson Atmix Corp. One kind of the magnetic powder may be used, or two or more kinds thereof may be used concurrently.

From a viewpoint to obtain the effects of the present invention more clearly, the content (% by volume) of the magnetic powder of the (A-2) component is, on the basis of 100% by volume of the non-volatile components in the resin composition, preferably 10% or more by volume, or 20% or more by volume, while more preferably 25% or more by volume, 30% or more by volume, or 35% or more by volume; and from a viewpoint to further improve the permeability, still more preferably 37% or more by volume, while especially preferably 39% or more by volume. From a viewpoint to obtain the effects of the present invention more clearly, the upper limit thereof is, on the basis of 100% by volume of the non-volatile components in the resin composition, preferably 80% or less by volume, or 75% or less by volume, while more preferably 70% or less by volume, or 65% or less by volume; and from a viewpoint to further improve the strength at a breaking point, still more preferably 60% or less by volume, while especially preferably 55% or less by volume. In one embodiment, the content (% by volume) of the magnetic powder of the (A-2) component is, on the basis of 100% by volume of the non-volatile components in the resin composition, preferably in the range of 10 to 80% by volume, more preferably in the range of 20 to 75% by volume, and still more preferably in the range of 25 to 70% by volume, while especially preferably in the range of 30 to 65% by volume, or in the range of 35 to 65% by volume.

From a viewpoint to obtain the effects of the present invention more clearly, the content (% by mass) of the magnetic powder of the (A-2) component is, on the basis of 100% by mass of the non-volatile components in the resin composition, preferably 20% or more by mass, or 30% or more by mass, while more preferably 40% or more by mass, or 50% or more by mass; and from a viewpoint to further improve the permeability, still more preferably 60% or more by mass, while especially preferably 63% or more by mass. From a viewpoint to obtain the effects of the present invention more clearly, the upper limit thereof is, on the basis of 100% by mass of the non-volatile components in the resin composition, preferably 95% or less by mass, while more preferably 90% or less by mass; and from a viewpoint to further improve the strength at a breaking point, still more preferably 80% or less by mass, while especially preferably 70% or less by mass. In one embodiment, the content (% by mass) of the magnetic powder of the (A-2) component is, on the basis of 100% by mass of the non-volatile components in the resin composition, preferably in the range of 20 to 95% by mass, more preferably in the range of 30 to 95% by mass, and still more preferably in the range of 40 to 90% by mass, while especially preferably in the range of 50 to 90% by mass.

The volume ratio of the (A-2) component to the (A-1) component ((A-2) component/(A-1) component) is 0.8 or more, and from a viewpoint to obtain the effects of the present invention more clearly, preferably 0.9 or more, while more preferably 1.0 or more; and from a viewpoint to further improve the permeability, still more preferably 1.1 or more, or 1.2 or more, while especially preferably 1.3 or more, or 1.4 or more. The upper limit thereof is 34.0 or less, and from a viewpoint to obtain the effects of the present invention more clearly, preferably 30.0 or less, or 25.0 or less, while more preferably 20.0 or less, or 15.0 or less; and from a viewpoint to further improve the strength at a breaking point, still more preferably 10.0 or less, or 5.0 or less, while especially preferably 3.0 or less, or 2.5 or less. In one embodiment, the volume ratio of the (A-2) component to the (A-1) component ((A-2) component/(A-1) component) is preferably in the range of 0.9 to 30.0, more preferably in the range of 0.9 to 25.0, and still more preferably in the range of 1.0 to 20.0, while especially preferably in the range of 1.0 to 15.0.

Although the content (% by volume) of (A) the magnetic powder is not particularly restricted, from a viewpoint to obtain the effects of the present invention more clearly, the content is, on the basis of 100% by volume of the non-volatile components in the resin composition, preferably 30% or more by volume, and more preferably 40% or more by volume, while still more preferably 50% or more by volume, or 55% or more by volume, while especially preferably 60% or more by volume, 62% or more by volume, or 65% or more by volume. From a viewpoint to obtain the effects of the present invention more clearly, the upper limit thereof is, on the basis of 100% by volume of the non-volatile components in the resin composition, preferably 90% or less by volume, more preferably 85% or less by volume, and still more preferably 80% or less by volume, while especially preferably 75% or less by volume. In one embodiment, the content (% by volume) of (A) the magnetic powder is, on the basis of 100% by volume of the non-volatile components in the resin composition, preferably in the range of 30 to 90% by volume, more preferably in the range of 40 to 85% by volume, and still more preferably in the range of 50 to 80% by volume, while especially preferably in the range of 60 to 75% by volume, or in the range of 65 to 75% by volume.

Although the content (% by mass) of (A) the magnetic powder is not particularly restricted, from a viewpoint to obtain the effects of the present invention more clearly, the content is, on the basis of 100% by mass of the non-volatile components in the resin composition, preferably 50% or more by mass, or 60% or more by mass, more preferably 70% or more by mass, or 75% or more by mass, still more preferably 80% or more by mass, or 85% or more by mass, while especially preferably 90% or more by mass, or 92% or more by mass. From a viewpoint to obtain the effects of the present invention more clearly, the upper limit thereof is, on the basis of 100% by mass of the non-volatile components in the resin composition, preferably 97% or less by mass, more preferably 95% or less by mass, and still more preferably 94% or less by mass, while especially preferably 93% or less by mass. In one embodiment, the content (% by mass) of (A) the magnetic powder is, on the basis of 100% by mass of the non-volatile components in the resin composition, preferably in the range of 50 to 97% by mass, or in the range of 60 to 97% by mass, more preferably in the range of 70 to 95% by mass, or in the range of 75 to 95% by mass, and still more preferably in the range of 80 to 94% by mass, or in the range of 85 to 94% by mass, while especially preferably in the range of 90 to 93% by mass, or in the range of 92 to 93% by mass.

### (A-3) Arbitrary Magnetic Powder

The (A) component may include (A-3) an arbitrary magnetic powder other than the (A-1) component and the (A-2) component. Illustrative examples of (A-3) the arbitrary magnetic powder may include a magnetic metal oxide powder and a magnetic metal powder.

The lower the content of (A-3) the arbitrary magnetic powder in the (A) component, the more preferable. The content of (A-3) the arbitrary magnetic powder is, on the basis of 100% by volume of the entire (A) component, preferably 5% or less by volume, and more preferably 2% or less by volume, while still more preferably 1% or less by volume. Also, the content is, on the basis of 100% by mass of the entire (A) component, preferably 5% or less by mass, and more preferably 2% or less by mass, while still more preferably 1% or less by mass. It is especially preferable that the (A) component does not contain (A-3) the arbitrary magnetic powder (i.e., 0% by volume and 0% by mass). Namely, it is especially preferable that the (A) component contains only the (A-1) component and the (A-2) component.

### (B) Thermosetting Resin

The resin composition according to the present invention includes (B) a thermosetting resin. Illustrative examples of (B) the thermosetting resin include an epoxy resin, an epoxy acrylate resin, a urethane acrylate resin, a urethane resin, a cyanate resin, a polyimide resin, a benzoxazine resin, an unsaturated polyester resin, a phenol resin, a melamine resin, a silicone resin, and a phenoxy resin.

Although the content of (B) the thermosetting resin (% by mass) is not particularly restricted, from a viewpoint to obtain the effects of the present invention more clearly, the content is, on the basis of 100% by mass of the non-volatile components in the resin composition, preferably 0.1% or more by mass, more preferably 1% or more by mass, and still more preferably 3% or more by mass, while especially preferably 5% or more by mass. Also, from a viewpoint to obtain the effects of the present invention more clearly, the upper limit thereof is, on the basis of 100% by mass of the non-volatile components in the resin composition, preferably 50% or less by mass, more preferably 30% or less by mass, and still more preferably 20% or less by mass, while especially preferably 10% or less by mass. In one embodiment, the content of (B) the thermosetting resin (% by mass) is, on the basis of 100% by mass of the non-volatile components in the resin composition, preferably in the range of 0.1 to 50% by mass, more preferably in the range of 1 to 30% by mass, and still more preferably in the range of 3 to 20% by mass, while especially preferably in the range of 5 to 10% by mass.

### (B-1) Epoxy Resin

It is preferable that the resin composition according to the present invention includes (B-1) an epoxy resin as (B) the thermosetting resin. The (B-1) epoxy resin means the resin having an epoxy group.

Illustrative examples of (B-1) the epoxy resin include a bixylenol type epoxy resin, a bisphenol A type epoxy resin, a bisphenol F type epoxy resin, a bisphenol S type epoxy resin, a bisphenol AF type epoxy resin, a dicyclopentadiene type epoxy resin, a trisphenol type epoxy resin, a naphthol novolak type epoxy resin, a phenol novolak type epoxy type resin, a tert-butyl-catechol type epoxy resin, a naphthalene type epoxy resin, a naphthol type epoxy resin, an anthracene type epoxy resin, a glycidyl amine type epoxy resin, a glycidyl ester type epoxy resin, a cresol novolak type epoxy resin, a biphenyl type epoxy resin, a linear aliphatic epoxy resin, an epoxy resin having a butadiene structure, an alicyclic epoxy resin, a heterocyclic epoxy resin, an epoxy resin having a spiro ring, a cyclohexane type epoxy resin, a cyclohexane dimethanol type epoxy resin, a naphthylene ether type epoxy resin, a trimethylol type epoxy resin, and a tetraphenylethane type epoxy resin. These epoxy resins may be used singly or as a combination of two or more of them.

It is preferable that the resin composition includes, as (B-1) the epoxy resin, an epoxy resin having two or more epoxy groups in one molecule. From a viewpoint to clearly obtain the intended effects of the present invention, the ratio of the epoxy resin having two or more epoxy groups in one molecule relative to 100% by mass of the non-volatile components in (B-1) the epoxy resin is preferably 50% or more by mass, and more preferably 60% or more by mass, while especially preferably 70% or more by mass.

In (B-1) the epoxy resin, there are an epoxy resin that is in the state of liquid at 25°C (hereinafter, this is also called "liquid epoxy resin") and an epoxy resin that is in the state of solid at 25°C (hereinafter, this is also called "solid epoxy resin"). The resin composition according to the present invention may include, as (B-1) the epoxy resin, only the liquid epoxy resin, or in addition to the liquid epoxy resin, the solid epoxy resin as a combination with the liquid epoxy resin. According to the preferred embodiment, only the liquid epoxy resin is included therein.

The content of the liquid epoxy resin is, on the basis of 100% by mass of the total epoxy resin, preferably 60% or more by mass, more preferably 80% or more by mass, and still more preferably 90% or more by mass, while especially preferably 100% by mass.

As the liquid epoxy resin, a liquid epoxy resin having two or more epoxy groups in one molecule thereof is preferable.

The liquid epoxy resin is preferably a glycyrol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolak type epoxy resin, an alicyclic epoxy resin having an ester skeleton, a cyclohexane dimethanol type epoxy resin, and an epoxy resin having a butadiene structure. Among these, the glycidyl ether type epoxy resin, the bisphenol A type epoxy resin, and the bisphenol F type epoxy resin are more preferable.

Specific examples of the liquid epoxy resin include: "HP4032", "HP4032D", and "HP4032SS" (all are naphthalene type epoxy resins) manufactured by DIC Corp.; "828US" and "jER828EL" (both resins are bisphenol A type epoxy resins), "jER807" (a bisphenol F type epoxy resin), and "jER152" (a phenol novolak type epoxy resin), all of these resins being manufactured by Mitsubishi Chemical Corp.; "630" and "630LSD", both resins being manufactured by Mitsubishi Chemical Corp.; "ED-523T" (a glycyrol type epoxy resin (Adeka glycyrol)), "EP-3980S" (a glycidyl amine type epoxy resin), and "EP-4088S" (a dicyclopentadiene type epoxy resin), all of these resins being manufactured by ADEKA Corp.; "ZX1059" (a mixture of a bisphenol A type epoxy resin and a bisphenol F type epoxy resin) manufactured by Nippon Steel Chemical & Material Co., Ltd.; "EX-721" (a glycidyl ester type epoxy resin) manufactured by Nagase ChemteX Corp.; "Celloxide-2021P" (an alicyclic epoxy resin having an ester skeleton) and "PB-3600" (an epoxy resin having a butadiene structure), both resins being manufactured by Daicel Corp.; and "ZX1658" and "ZX1658GS" (liquid 1,4-glycidylcyclohexane) both resins being manufactured by Nippon Steel Chemical & Material Co., Ltd.

As the solid epoxy resin, a solid epoxy resin having three or more epoxy groups in one molecule thereof is preferable, while an aromatic solid epoxy resin having three or more epoxy groups in one molecule thereof is more preferable.

The solid epoxy resin is preferably a bixylenol type epoxy resin, a naphthalene type epoxy resin, a naphthalene type four-functional epoxy resin, a naphthol novolak type epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, a phenol aralkyl type epoxy resin, a tetraphenylethane type epoxy resin, a phenolphthalimidine type epoxy resin, and a phenolphthalein type epoxy resin.

Specifically, illustrative examples of the solid epoxy resin include "HP4032H" (a naphthalene epoxy type resin) manufactured by DIC Corp.; "HP-4700" and "HP-4710" (both are naphthalene type four-functional epoxy resins) manufactured by DIC Corp.; "N-690" (a cresol novolak type epoxy resin) manufactured by DIC Corp.; "N-695" (a cresol novolak type epoxy resin) manufactured by DIC Corp.; "HP-7200", "HP-7200HH", "HP-7200H", and "HP-7200L" (these are dicyclopentadiene type epoxy resins) manufactured by DIC Corp.; "EXA-7311", "EXA-7311-G3", "EXA-7311-G4", "EXA-7311-G4S", and "HP6000" (these are naphthylene ether type epoxy resins) manufactured by DIC Corp.; "EPPN-502H" (a trisphenol type epoxy resin) manufactured by Nippon Kayaku Co., Ltd.; "NC7000L" (a naphthol novolak type epoxy resin) manufactured by Nippon Kayaku Co., Ltd.; "NC3000H", "NC3000", "NC3000L", "NC3000FH", and "NC3100" (these are biphenyl type epoxy resins) manufactured by Nippon Kayaku Co., Ltd.; "ESN475V" (a naphthalene type epoxy resin) manufactured by Nippon Steel Chemical & Materials Co., Ltd.; "ESN485" (a naphthol type epoxy resin) manufactured by Nippon Steel Chemical & Materials Co., Ltd.; "ESN375" (a dihydroxynaphthalene type epoxy resin) manufactured by Nippon Steel Chemical & Materials Co., Ltd.; "YX4000H", "YX4000", "YX4000HK", and "YL7890" (these are bixylenol type epoxy resins) manufactured by Mitsubishi Chemical Corp.; "YL6121" (a biphenyl type epoxy resin) manufactured by Mitsubishi Chemical Corp.;"YX8800" (an anthracene type epoxy resin) manufactured by Mitsubishi Chemical Corp.; "YX7700" (a phenol aralkyl type epoxy resin) manufactured by Mitsubishi Chemical Corp.; "PG-100" and "CG-500" both manufactured by Osaka Gas Chemicals Co., Ltd.; "YL7760" (a bisphenol AF type epoxy resin) manufactured by Mitsubishi Chemical Corp.; "YL7800" (a fluorene type epoxy resin) manufactured by Mitsubishi Chemical Corp.; "jER1010" (a bisphenol A type epoxy resin) manufactured by Mitsubishi Chemical Corp.; "jER1031S" (a tetraphenylethane type epoxy resin) manufactured by Mitsubishi Chemical Corp.; and "WHR991S" (a phenolphthalimidine type epoxy resin) manufactured by Nippon Kayaku Co., Ltd. These may be used singly or as a combination of two or more of them.

When the solid epoxy resin and the liquid epoxy resin are concurrently used as (B-1) the epoxy resin, although the mass ratio of the solid epoxy resin to the liquid epoxy resin (solid epoxy resin/liquid epoxy resin) is not particularly restricted, this is preferably 1 or less, more preferably 0.5 or less, still more preferably 0.1 or less, and far still more preferably 0.05 or less, while especially preferably 0.01 or less.

The epoxy equivalent of (B-1) the epoxy resin is preferably in the range of 50 to 5,000 g/eq., more preferably in the range of 50 to 3,000 g/eq., and still more preferably in the range of 80 to 2,000 g/eq., while far still more preferably in the range of 110 to 1,000 g/eq. The epoxy equivalent is a mass of a resin per one equivalent of the epoxy group thereof. The epoxy equivalent may be measured in accordance with JIS K7236.

From a viewpoint to clearly obtain the intended effects of the present invention, the weight-average molecular weight (Mw) of (B-1) the epoxy resin is preferably in the range of 100 to 5,000, and more preferably in the range of 250 to 3,000, while still more preferably in the range of 400 to 1,500. The weight-average molecular weight of the resin may be measured by a value in terms of polystyrene by a gel permeation chromatography (GPC) method.

The content (% by mass) of (B-1) the epoxy resin is not particularly restricted. From a viewpoint to obtain the effects of the present invention more clearly, the content is, on the basis of 100% by mass of the non-volatile components in the resin composition, preferably 0.1% or more by mass, more preferably 1% or more by mass, and still more preferably 3% or more by mass, while especially preferably 5% or more by mass. From a viewpoint to obtain the effects of the present invention more clearly, the upper limit thereof is, on the basis of 100% by mass of the non-volatile components in the resin composition, preferably 50% or less by mass, more preferably 30% or less by mass, and still more preferably 20% or less by mass, while especially preferably 10% or less by mass. In one embodiment, the content (% by mass) of (B-1) the epoxy resin is, on the basis of 100% by mass of the non-volatile components in the resin composition, preferably in the range of 0.1 to 50% by mass, more preferably in the range of 1 to 30% by mass, and still more preferably in the range of 3 to 20% by mass, while especially preferably in the range of 5 to 10% by mass.

### (B-2) Epoxy Curing Accelerator

The resin composition according to the present invention may further include, as an arbitrary component, (B-2) an epoxy curing accelerator, when it includes (B-1) the epoxy resin as (B) the thermosetting resin. (B-2) The epoxy curing accelerator has a function to facilitate to cure (B-1) the epoxy resin.

Illustrative examples of (B-2) the epoxy curing accelerator include an imidazole type curing accelerator, a phosphorous type curing accelerator, a urea type curing accelerator, a guanidine type curing accelerator, a metal type curing accelerator, and an amine type curing accelerator. In one embodiment, (B-2) the epoxy curing accelerator preferably includes the imidazole type curing accelerator. (B-2) These curing accelerators may be used singly or as a mixture of two or more of them.

Illustrative examples of the imidazole type curing accelerator include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin.

Commercially available imidazole type curing accelerators may be used. Illustrative examples thereof include "1B2PZ", "2MZA-PW", "2PHZ-PW" manufactured by Shikoku Chemicals Corp., and "P200-H50" manufactured by Mitsubishi Chemical Corp.

Illustrative examples of the phosphorous type curing accelerator include: aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, bis(tetrabutylphosphonium) pyromellitate, tetrabutylphosphonium hydrogen hexahydrophthalate, tetrabutylphosphonium 2,6-bis[(2-hydroxy-5-methylphenyl)methyl]-4-methylphenolate, and di-tert-butylmethylphosphonium tetraphenylborate; aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate; aromatic phosphine-borane complexes such as triphenylphosphine-triphenylborane; aromatic phosphine-quinone addition reaction products such as a triphenylphosphine-p-benzoquinone addition reaction product; aliphatic phosphines such as tributylphosphine, tri-tert-butylphosphine, trioctylphosphine, di-tert-butyl(2-butenyl)phosphine, di-tert-butyl(3-methyl-2-butenyl)phosphine, and tricyclohexylphosphine; and aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl)phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl)phosphine, tris(2,4,6-trimethylphenyl)phosphine, tris(2,6-dimethyl-4-ethoxyphenyl)phosphine, tris(2-methoxyphenyl)phosphine, tris(4-methoxyphenyl)phosphine, tris(4-ethoxyphenyl)phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenyl ether.

Illustrative examples of the urea type curing accelerator include: 1,1-dimethylurea; aliphatic dimethylureas such as 1,1,3-trimethylurea, 3-ethyl-1,1-dimethylurea, 3-cyclohexyl-1,1-dimethylurea, and 3-cyclooctyl-1,1-dimethylurea; and aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene)bis(N',N'-dimethylurea), and N,N-(4-methyl-1,3-phenylene)bis(N',N'-dimethylurea) [toluenebisdimethylurea].

Illustrative examples of the guanidine type curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7-methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide.

Illustrative examples of the metal type curing accelerator include organic metal complexes or organic metal salts of metals such as cobalt, copper, zinc, iron, nickel, manganese, and tin. Specific examples of the organic metal complex include organic cobalt complexes such as cobalt(II) acetylacetonate and cobalt(III) acetylacetonate; organic copper complexes such as copper(II) acetylacetonate; organic zinc complexes such as zinc(II) acetylacetonate; organic iron complexes such as iron(III) acetylacetonate; organic nickel complexes such as nickel(II) acetylacetonate; and organic manganese complexes such as manganese(II) acetylacetonate. Illustrative examples of the organic metal salt include zinc octylate, tin octylate, zinc naphthenate, cobalt naphthenate, tin stearate, and zinc stearate.

Illustrative examples of the amine type curing accelerator include: trialkyl amines such as triethylamine and tributylamine; and 4-dimethylaminopyridine, benzyldimethylamine, 2,4,6-tris(dimethylaminomethyl)phenol, and 1,8-diazabicyclo(5,4,0)-undecene.

Commercially available amine type curing accelerators may be used. Illustrative examples thereof include "MY-25" manufactured by Ajinomoto Fine-Techno Co., Ltd.

The content (% by mass) of (B-2) the epoxy curing accelerator is not particularly restricted. The content is preferably 10% or less by mass, more preferably 5% or less by mass, and still more preferably 2% or less by mass, while especially preferably 1% or less by mass, on the basis of 100% by mass of nonvolatile components in the resin composition. The lower limit thereof can be, for example, 0% or more by mass, 0.01% or more by mass, 0.1% or more by mass, or 0.5% or more by mass, on the basis of 100% by mass of nonvolatile components in the resin composition. In one embodiment, the content (% by mass) of (B-2) the epoxy curing accelerator is, on the basis of 100% by mass of nonvolatile components in the resin composition, preferably in the range of 0 to 10% by mass, more preferably in the range of 0 to 5% by mass, and still more preferably in the range of 0 to 2% by mass, while especially preferably in the range of 0 to 1% by mass.

### (B-3) Epoxy Curing Agent

The resin composition according to the present invention may further include, as an arbitrary component, (B-3) an epoxy curing agent, when it includes (B-1) the epoxy resin as (B) the thermosetting resin. (B-3) The epoxy curing agent have a function to cure (B-1) the epoxy resin by reaction therewith.

(B-3) The epoxy curing agent is not particularly restricted. Illustrative examples thereof include a phenol type curing agent, a carbodiimide type curing agent, an acid anhydride type curing agent, an amine type curing agent, a benzoxazine type curing agent, a cyanate ester type curing agent, and a thiol type curing agent. (B-3) These epoxy curing agents may be used singly or as a combination of two or more of them. (B-3) The epoxy curing agent preferably includes the phenol type curing agent.

Although the phenol type curing agent is not particularly restricted, it is preferably a biphenyl type curing agent, a naphthalene type curing agent, a phenol novolac type curing agent, a naphthylene ether type curing agent, and a phenol type curing agent having a triazine skeleton. Specific examples thereof include "MEH-7700", "MEH-7810", and "MEH-7851" manufactured by Meiwa Plastic Industries, Ltd. that are the biphenyl type curing agent; "NHN", "CBN", and "GPH" manufactured by Nippon Kayaku Co., Ltd., "SN170", "SN180", "SN190", "SN475", "SN485", "SN495", "SN375", and "SN395" manufactured by Nippon Steel Chemical & Materials Co., Ltd., "EXB9500" manufactured by DIC Corp. that are the naphthalene type curing agent; "TD2090" manufactured by DIC Corp. that is the phenol novolac type curing agent; "EXB-6000" manufactured by DIC Corp. that is the naphthylene ether type curing agent. Specific examples of the phenol type curing agent having a triazine skeleton include "LA3018", "LA7052", "LA7054", and "LA1356" manufactured by DIC Corp. Above all, the phenol type curing agent is more preferably the naphthalene type curing agent, and the phenol type curing agent having a triazine skeleton.

Illustrative examples of the carbodiimide type curing agent include a curing agent having one or more, preferably two or more, carbodiimide structures in one molecule. Specific examples thereof include biscarbodiimides such as aliphatic biscarbodiimides such as tetramethylene-bis(t-butylcarbodiimide), cyclohexane bis(methylene-t-butylcarbodiimide); aromatic biscarbodiimides such as phenylene-bis(xysilylcarbodiimide); polycarbodiimides such as aliphatic polycarbodiimides such as polyhexamethylene carbodiimide, polytrimethylhexamethylene carbodiimide, polycyclohexylene carbodiimide, poly(methylenebiscyclohexylene carbodiimide), poly(isophorone carbodiimide); aromatic polycarbodiimides such as poly(phenylene carbodiimide), poly(naphthylene carbodiimide), poly(trilene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylene diphenylene carbodiimide), poly[methylene bis(methylphenylene) carbodiimide].

Illustrative examples of the carbodiimide type curing agent that is commercially available include "Carbodilite V-02B", "Carbodilite V-03", "Carbodilite V-04K", "Carbodilite V-07", and "Carbodilite V-09" manufactured by Nisshinbo Chemical, Inc.; "Stabaxol P", "Stabaxol P400", and "Hycasyl 510" manufactured by Rheinchemie.

The acid anhydride type curing agent may be a curing agent having one or more acid anhydride groups in one molecule thereof, and a curing agent having two or more acid anhydride groups in one molecule thereof is preferable. Specific examples of the acid anhydride type curing agent include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenylsuccinic anhydride, 5-(2,5-dioxotetrahydro-3-furanyl)-3-methyl-3-cyclohexene-1,2-dicarboxylic anhydride, trimellitic anhydride, pyromellitic anhydride, benzophenonetetracarboxylic dianhydride, biphenyltetracarboxylic dianhydride, naphthalenetetracarboxylic dianhydride, oxydiphthalic dianhydride, 3,3'-4,4'-diphenylsulfonetetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and an anhydride of a polymer type acid such as a styrene-maleic acid resin obtained by copolymerizing styrene and maleic acid. Illustrative examples of the acid anhydride type curing agent that is commercially available include: "HNA-100", "MH-700", "MTA-15", "DDSA", and "OSA" manufactured by New Japan Chemical Co., Ltd.; "YH-306" and "YH-307" manufactured by Mitsubishi Chemical Corp.; and "HN-2200" and "HN-5500" manufactured by Hitachi Chemical Co., Ltd.

The amine type curing agent may be a curing agent having one or more amino groups, preferably two or more amino groups, in one molecule thereof. Illustrative examples thereof include aliphatic amines, polyether amines, alicyclic amines, and aromatic amines. Among these, from a viewpoint to clearly express intended effects of the present invention, aromatic amines are preferable. The amine type curing agent is preferably a primary amine or a secondary amine, while a primary amine is more preferable. Specific examples of the amine type curing agent include 4,4'-methylenebis(2,6-dimethylaniline), 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type curing agents may be used as well. Illustrative examples thereof include: "SEIKACURE-S" manufactured by SEIKA Corp.; "KAYABOND C-200S", "KAYABOND C-100", "KAYAHARD A-A", "KAYAHARD A-B", and "KAYAHARD A-S" manufactured by Nippon Kayaku Co., Ltd.); and "Epicure W" manufactured by Mitsubishi Chemical Corp.

Specific examples of the benzoxazine type curing agent include "JBZ-OP100D" and "ODA-BOZ" manufactured by JFE Chemical Corp.; "HFB2006M" manufactured by Showa Highpolymer Co., Ltd.; and "P-d" and "F-a" manufactured by Shikoku Chemicals Corp.

Illustrative examples of the cyanate ester type curing agent include: bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolak, a cresol novolak, and the like; and a prepolymer in which these cyanate resins are partially made to triazine. Specific examples of the cyanate ester type curing agent include "PT30" and "PT60" (both are phenol novolak type polyfunctional cyanate ester resins); and "BA230" and "BA230S75" (both are prepolymers in which part or all of bisphenol A dicyanate is made to triazine so as to be a trimer); all of these agents being manufactured by Lonza Japan Ltd.

Illustrative examples of the thiol type curing agent include trimethylolpropane tris(3-mercaptopropionate), pentaerythritol tetrakis(3-mercaptobutyrate), and tris(3-mercaptopropyl) isocyanurate.

The reaction group equivalent of (B-3) the epoxy curing agent is preferably in the range of 50 g/eq. to 3,000 g/eq., more preferably in the range of 100 g/eq. to 1,000 g/eq., and still more preferably in the range of 100 g/eq. to 500 g/eq., while especially preferably in the range of 100 g/eq. to 300 g/eq. The reaction group equivalent is a mass of the epoxy curing agent per one equivalent of the reaction group thereof.

The content (% by mass) of (B-3) the epoxy curing agent is not particularly restricted. The content is preferably 40% or less by mass, more preferably 30% or less by mass, and still more preferably 20% or less by mass, while especially preferably 10% or less by mass, on the basis of 100% by mass of nonvolatile components in the resin composition. The lower limit thereof can be, for example, 0% or more by mass, 0.01% or more by mass, or 0.1% or more by mass, on the basis of 100% by mass of nonvolatile components in the resin composition. In one embodiment, the content (% by mass) of (B-3) the epoxy curing agent is, on the basis of 100% by mass of nonvolatile components in the resin composition, preferably in the range of 0 to 40% or less by mass, more preferably in the range of 0 to 30% or less by mass, and still more preferably in the range of 0 to 20% or less by mass, while especially preferably in the range of 0 to 10% or less by mass.

### (C) Other Additive

The resin composition according to the present invention may further include, as the non-volatile component, an arbitrary additive. Illustrative examples of the additive like this include: radical-polymerizable compounds such as a maleimide type radical-polymerizable compound, a vinylphenyl type radical-polymerizable compound, a (meth)acrylic radical-polymerizable compound, an allyl type radical-polymerizable compound, and a polybutadiene type radical-polymerizable compound; radical polymerization initiators such as a peroxide type radical polymerization initiator and an azo type radical polymerization initiator; thermoplastic resins such as a polyvinylacetal resin, a polyolefin resin, a polysulfone resin, a polyether sulfone resin, a polyphenylene ether resin, a polycarbonate resin, a polyether ether ketone resin, and a polyester resin; organic fillers such as a rubber particle; organometallic compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant and a hindered amine type antioxidant; fluorescent whitening agents such as a stilbene derivative; surfactants such as a fluorine type surfactant and a silicone type surfactant; flame retardants such as phosphorous type flame retardants (for example, phosphate esters, phosphazene compounds, phosphinate compounds, and red phosphorous), nitrogen type flame retardants (for example, melamine sulfate), halogen type flame retardants, and inorganic type flame retardants (for example, antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer ,a titanate type stabilizer, an aluminate type stabilizer, a zirconate type stabilizer, an isocyanate type stabilizer, a carboxylate type stabilizer, and a carboxylic anhydride type stabilizer. (C) The other additive may be used singly or as a combination of two or more of them with an arbitrary ratio. The contents of (C) the other additives may be readily determined by a person ordinarily skilled in the art.

### (D) Organic Solvent

Occasionally, the resin composition according to the present invention further includes, in addition to the non-volatile components described above, an arbitrary organic solvent as a volatile component. Heretofore known solvents may be arbitrarily used as (D) the organic solvent without any particular restriction so far as it can dissolve at least part of the non-volatile components. Illustrative examples of (D) the organic solvent include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethylene glycol; ether ester type solvents such as 2-ethoxyethyl acetate, propylene glycol monomethyl ether acetate, diethylene glycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propylene glycol monomethyl ether, and diethylene glycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (D) The organic solvent may be used singly or as a combination of two or more of the solvents with an arbitrary ratio. When (D) the organic solvent is used, the organic solvent may be used singly or as a combination of two or more of the solvents with an arbitrary ratio. In one embodiment, the lower the content of (D) the organic solvent, the more preferable (for example, 3% or less by mass, 1% or less by mass, 0.5% or less by mass, 0.1% or less by mass, and 0.01% or less by mass, on the basis of 100% by mass of the non-volatile components in the resin composition); it is particularly preferable when the organic solvent is not included therein (0% by mass).

### Characteristics of the Resin Composition

The resin composition according to the present invention includes (A) the magnetic powder and (B) the thermosetting resin, in which (A) the magnetic powder includes (A-1) the ferrite powder having the average particle diameter of 0.8 µm or less and (A-2) the magnetic powder having the average particle diameter of 1.5 µm or more; and the volume ratio of the magnetic powder of the (A-2) component to the ferrite powder of the (A-1) component ((A-2) component/(A-1) component) is in the range of 0.8 to 34.0. When the resin composition like this is used, the magnetic material (cured product) that is superior in the mechanical strength and the relative permeability can be obtained.

The cured product of the resin composition according to the present invention can have a superior relative permeability (µ'). Accordingly, in one embodiment, the relative permeability (µ') of the cured product of the resin composition upon this is measured with the measurement frequency of 100 MHz at 23°C as described in Test Example 1 to be described later can be preferably 5.0 or more, or 6.0 or more, more preferably 7.0 or more, or 8.0 or more, still more preferably 9.0 or more, or 9.5 or more, while especially preferably 10.0 or more, or 10.5 or more.

The cured product of the resin composition according to the present invention can have a superior mechanical strength. Accordingly, in one embodiment, the tensile strength at a breaking point of the cured product of the resin composition, which is measured in accordance with JIS K7127 as described in Test Example 2 to be described later, can be preferably 30 MPa or more, or 35 MPa or more, more preferably 40 MPa or more, or 45 MPa or more, still more preferably 50 MPa or more, or 55 MPa or more, while especially preferably 60 MPa or more, or 62 MPa or more.

In one embodiment, when the cured product of the resin composition according to the present invention is cut to observe the section of the cured product thereof by a scanning electron microscope (SEM), the (A-1) component and the (A-2) component can appear in the section of the cured product. In one embodiment, it can be observed that larger particles of the (A-2) component appear in the section of the cured product, and that the resin component (namely, the post-cure components other than the (A) components in the non-volatile components of the resin composition) fills the space among these particles of the (A-2) component, and that particles of the (A-1) component are included in the resin component in such a way as to be dispersed therein. In this embodiment, because the (A-1) component is dispersed in the resin component, the contact of the particles of the (A-1) component and the (A-2) component among themselves is less as compared with the mere closest packing of the magnetic powder particles. In the embodiment like this, a further improvement action in the mechanical strength due to the resin component can be obtained.

### Production Method of the Resin Composition

The resin composition according to the present invention may be produced, for example, by adding into an arbitrary preparation vessel (A) the magnetic powder, (B) the thermosetting resin, optionally (C) other additive, and optionally (D) the organic solvent, in an arbitrary order and/or partially or simultaneously all at once, followed by mixing them. During the addition and mixing of these components, the temperatures of them may be appropriately controlled; and in addition, they may be heated and/or cooled temporally or throughout the process. During the addition and mixing of them, stirring or shaking may be carried out. During the time of addition and mixing or thereafter, the resin composition may be uniformly dispersed by stirring or shaking by using the stirring equipment such as, for example, a mixer or shaking equipment. Also, at the same time with stirring or shaking, defoaming may be carried out under a low-pressure condition such as under a vacuum condition.

### Resin Composition

Upon forming the magnetic cured product of the substrate, the resin composition may be used in the form of a paste-like resin composition at normal temperature (25°C) or in the form of a resin sheet that includes a layer of the resin composition.

In one embodiment, the resin composition may be used as the paste-like resin composition by using an organic solvent, or as the paste-like resin sheet not containing an organic solvent by using a liquid thermosetting resin such as a liquid epoxy resin. When the amount of the organic solvent is small or when the organic solvent is not included in the resin composition, not only generation of voids due to evaporation of the organic solvent can be suppressed but also the handling property and workability thereof can be improved.

In one embodiment, the resin composition may be suitably used as the resin composition to fill the through hole. Also, in one embodiment, the resin composition may be suitably used as the resin composition for the inductor base element to produce an inductor element.

### Resin Sheet

The resin sheet includes a support and a resin composition layer formed on the support, the resin composition layer being formed of the resin composition of the present invention.

From a viewpoint of thinning, thickness of the resin composition layer is preferably 250 µm or less, and more preferably 200 µm or less. Although the lower limit of the thickness of the resin composition layer is not particularly restricted, it can be usually 5 µm or more, 10 µm or more, or the like.

Illustrative examples of the support include a film formed of a plastic material, metal foil, and a releasing paper. Among them, a film formed of a plastic material and metal foil are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC"); acrylic polymers such as polymethyl methacrylate (PMMA); a cyclic polyolefin; triacetylcellulose (TAC); polyether sulfide (PES); polyether ketone; and polyimide. Among them, polyethylene terephthalate and polyethylene naphthalate are preferable, while cheap polyethylene terephthalate is especially preferable.

When the metal foil is used as the support, illustrative examples of the metal foil include copper foil and aluminum foil, while copper foil is preferable. As to the copper foil, the foil formed of a copper single metal or an alloy of copper with other metal (for example, tin, chromium, silver, magnesium, nickel, zirconium, silicon, and titanium) may be used.

The support may be subjected to a treatment such as a mat treatment, or a corona treatment on the surface to be bonded with the resin composition layer.

As for the support, the releasing layer-attached support having the releasing layer on the surface to be bonded with the resin composition layer may also be used. The releasing agent to be used for the releasing layer of the releasing layer-attached support is, for example, one or more releasing agents selected from the group consisting of an alkyd type releasing agent, a polyolefin type releasing agent, a urethane type releasing agent, and a silicone type releasing agent. Commercially available products may be use as the leasing layer-attached support; they are, for example, a PET film having the releasing layer formed of mainly the silicone type releasing agent or the alkyd resin type releasing agent. Illustrative examples thereof include: "PET501010", "SK-1", "AL-5", and "AL-7" (all are manufactured by Lintec Corp.); "Lumirror T60" (manufactured by Toray Industries); "Purex" (manufactured by Teijin Ltd.); and "Unipeel" (manufactured by Unitika Ltd.).

Although thickness of the support is not particularly restricted, this is preferably in the range of 5 to 75 µm, while more preferably in the range of 10 to 60 µm. When the releasing layer-attached support is used, total thickness of the releasing layer-attached support is preferably within this range.

In the resin sheet, a protection film similar to the support may be further laminated on the surface of the resin composition layer not bonded to the support (namely, on the surface opposite to the support). Although thickness of the protection film is not particularly restricted, for example, this is in the range of 1 to 40 µm. By laminating the protection film, the surface of the resin composition layer may be prevented from attachment of dirt and the like as well as from a scar. The resin sheet can be rolled up so as to be stored. When the resin sheet has the protection film, the resin sheet can be used by removing the protection film.

The resin sheet may be produced, for example, by forming the resin composition layer on the support by applying the resin composition on the support by means of a die coater or the like. As needed, the resin composition is mixed with an organic solvent; and then, this may be applied onto the support. When the organic solvent is used, as needed, drying may be carried out after the application.

Drying may be carried out by heating, blowing with a hot air, or the like. The drying condition is not particularly restricted. The drying is carried out under the drying condition so as to bring the content of the organic solvent in the resin composition layer to 10% or less by mass, while preferably 5% or less by mass. The resin composition layer may be formed by drying in the temperature range of 50 to 150°C for 3 to 10 minutes, although the condition is different depending on the components included in the resin composition.

The resin sheet can be rolled up so as to be stored. When the resin sheet has the protection film, the resin sheet can be used by removing the protection film.

### Circuit substrate and Production Method thereof

The circuit substrate according to the present invention includes a cured product of the resin composition. The circuit substrate according to a first embodiment includes a substrate having a through hole and a cured product of the resin composition according to the present invention, in which the cured product is filled in the through hole. The circuit substrate according to a second embodiment includes a cured product layer formed of the cured product of the resin composition layer in the resin sheet. Hereinafter, the first embodiment and the second embodiment with regard to the production method of the circuit substrate will be explained. Note that the production method of the circuit substrate relating to the present invention is not limited to the first embodiment or the second embodiment exemplified below.

### First Embodiment

The circuit substrate according to the first embodiment is produced, for example, by the production method including following processes (1) to (5). In the first embodiment, it is preferable to form the cured product by using the resin composition, while it is more preferable to form the cured product by using the resin composition in a paste-like form.
(1) A process at which the resin composition is filled in a through hole of the substrate having the through hole;
(2) a process at which the resin composition is thermally cured to obtain a cured product;
(3) a process at which a surface of the cured product or of the resin composition is polished;
(4) a process at which the cured product is subjected to a roughening treatment; and
(5) a process at which a conductive layer is formed on a roughened surface of the cured product.

The production method of the circuit substrate according to the present invention may be carried out in the order of the processes (1) to (5), or the process (2) may be carried out after the process (3).

### Process (1)

Upon carrying out the process (1), the process may include a preparation process of the resin composition. The resin composition has already been explained above.

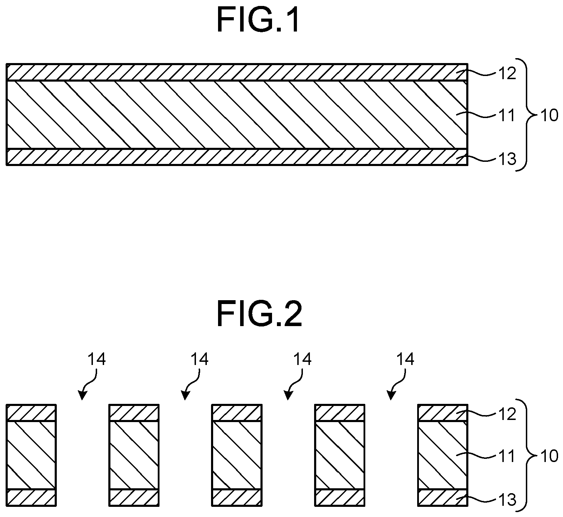

Upon carrying out the process (1), as illustrated in Fig. 1 as one example, the process may include a process to prepare a core substrate 10 having a supporting substrate 11, and a first metal layer 12 and a second metal layer 13 that are formed of a metal such as copper foil on both surfaces of the supporting substrate 11. Illustrative examples of the material of the supporting substrate 11 include an insulating substrate such as a glass epoxy substrate, a metal substrate, a polyester substrate, a polyimide substrate, a BT resin substrate, and a thermosetting type polyphenylene ether substrate. Illustrative examples of the material of the first and the second metal layers include carrier-attached copper foil and a material of the conductive layer to be described later.

In addition, as illustrated in Fig. 2 as one example, the process may include a process to form a through hole 14 in the core substrate 10. The through hole 14 may be formed, for example, by a drill, a laser irradiation, or a plasma irradiation. Specifically, the through hole 14 may be formed by forming a penetrating hole in the core substrate 10 by using a drill or the like.

Formation of the through hole 14 may be carried out by using a drilling machine that is commercially available. Illustrative examples of the commercially available drilling machine include "ND-1S211" manufactured by Hitachi Via Mechanics, Ltd.

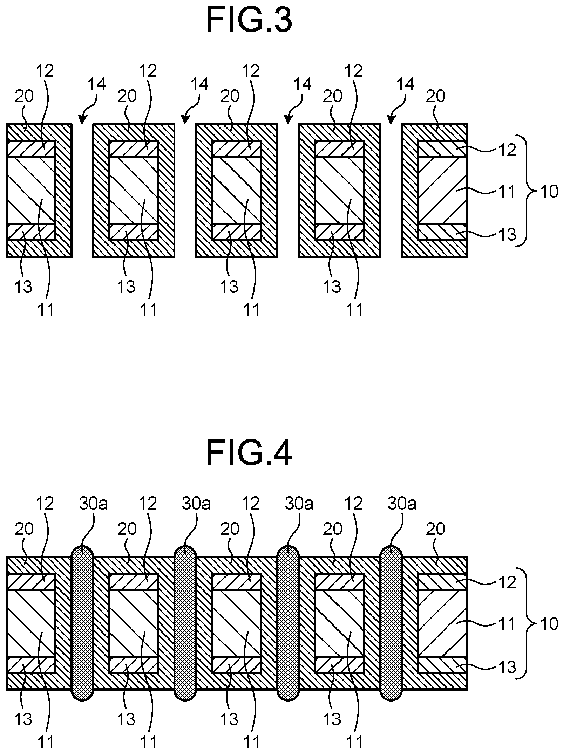

After the through hole 14 is formed in the core substrate 10, as illustrated in Fig. 3 as one example, the process may include a process to carry out a roughening treatment to the core substrate 10 followed by formation of a plated layer 20 in the through hole 14, on the surface of the first metal layer 12, and on the surface of the second metal layer 13.

The roughening treatment may be carried out with any of a dry roughening treatment and a wet roughening treatment. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order.

The plated layer 20 is formed by a plating method. The procedure to form the plated layer 20 by the plating method is the same as that in formation of a conductive layer at the process (5) to be described later.

After the core substrate 10 is prepared, as illustrated in Fig. 4 as one example, a resin composition 30a is filled into the through hole 14. The filling may be carried out, for example, by a printing method. Illustrative examples of the printing method include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### Process (2)

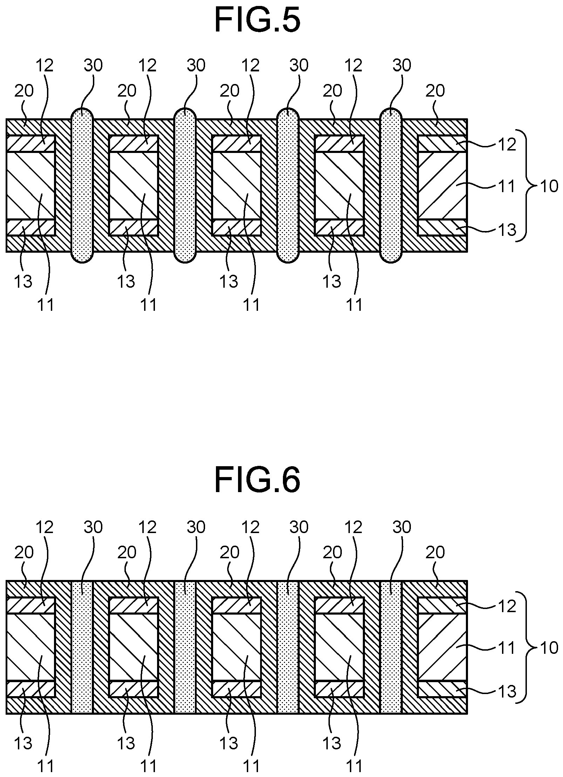

After the resin composition 30a is filled into the through hole 14, at the process (2), the resin composition 30a is thermally cured to form a cured product 30 in the through hole 14, as illustrated in Fig. 5 as one example. The thermal curing condition of the resin composition 30a is different depending on the composition and kind of the resin composition 30a. The curing temperature is preferably 120°C or higher, and more preferably 130°C or higher, while still more preferably 150°C or higher, and preferably 245°C or lower, and more preferably 220°C or lower, while still more preferably 200°C or lower. The curing time of the resin composition 30a is preferably 5 minutes or longer, and more preferably 10 minutes or longer, while still more preferably 15 minutes or longer, and preferably 120 minutes or shorter, and more preferably 110 minutes or shorter, while still more preferably 100 minutes or shorter.

The curing degree of the cured product 30 at the process (2) is preferably 80% or more, and more preferably 85% or more, while still more preferably 90% or more. The curing degree may be measured, for example, by using a differential scanning calorimeter.

Before the resin composition 30a is thermally cured, the resin composition 30a may be subjected to a preliminary heat treatment by heating at the temperature lower than the curing temperature. For example, prior to the thermal curing of the resin composition 30a, the resin composition 30a may be preliminary heated usually in the temperature range of 50°C or higher to lower than 120°C (preferably in the range of 60°C or higher to 110°C or lower, while more preferably in the range of 70°C or higher to 100°C or lower), and for the period of usually 5 minutes or longer (preferably for the period of 5 to 150 minutes, while more preferably for the period of 15 to 120 minutes).

### Process (3)

At the process (3), as illustrated in Fig. 6 as one example, an excess amount of the cured product 30 that is projected from or attached to the core substrate 10 is removed by polishing to make the surface thereof flat. The polishing method with which the excess amount of the cured product 30 that is projected from or attached to the core substrate 10 can be polished may be used. Illustrative examples of the polishing method like this include a buff polishing method and a belt polishing method. Illustrative example of the buff polishing equipment that is commercially available includes "NT-700IM" manufactured by Ishiihyoki Co., Ltd.

From a viewpoint to enhance the adhesion with the plated layer, the arithmetic average roughness (Ra) of the polished surface of the cured product 30 (cured product layer after thermal curing) is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured by using, for example, a non-contact type surface roughness meter.

When the process (3) is carried out after the process (2), among other purposes, with a purpose to further increase the curing degree of the cured product 30, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

### Process (4)

At the process (4), the surface having been polished at the process (3) is subjected to a roughening treatment (desmearing treatment). The procedure and the condition of the roughening process are not particularly restricted; so, heretofore known procedure and condition that are usually used in the production method of a multilayer printed wiring board may be used. At the roughening process, the cured product 30 may be roughened, for example, by carrying out a swelling treatment with a swelling liquid, a roughening treatment with an oxidant, and a neutralization treatment with a neutralizing solution in this order.

The swelling liquid to be used in the roughening process is not particularly restricted. Illustrative examples thereof include an alkaline solution, and a surfactant solution. Here, the alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU" both manufactured by Atotech Japan Co., Ltd.

The swelling treatment with the swelling liquid is not particularly restricted. For example, this can be carried out by soaking the core substrate 20 formed with the cured product 30 into the swelling liquid in the temperature range of 30 to 90°C and for the period of 1 to 20 minutes. From a viewpoint to suppress swelling of the resin that constitutes the cured product 30 to a suitable level, it is preferable to soak the cured product 30 into the swelling liquid in the temperature range of 40 to 80°C and for the period of 5 to 15 minutes.

The oxidant to be used in the roughening treatment by the oxidant is not particularly restricted. Illustrative examples thereof include an alkaline permanganate solution having potassium permanganate or sodium permanganate dissolved into a sodium hydroxide aqueous solution. The roughening treatment using an oxidant such as the alkaline permanganate solution or the like may be carried out preferably by soaking the cured product 30 into the oxidant solution heated at 60 to 80°C for the period of 10 to 30 minutes. The concentration of the permanganate salt in the alkaline permanganate solution is preferably in the range of 5 to 10% by mass. Illustrative examples of the oxidant that is commercially available include alkaline permanganate solutions such as "Concentrate Compact P" and "Dosing Solution Securiganth P" both manufactured by Atotech Japan, Co., Ltd.

The neutralization solution to be used in the neutralization treatment is preferably an acidic aqueous solution. Illustrative examples as the commercially available product thereof include "Reduction Solution Securiganth P" manufactured by Atotech Japan Co., Ltd. Neutralization treatment with the neutralization solution may be carried out by soaking the surface having been treated with the roughening treatment using the oxidant solution into the neutralization solution in the temperature range of 30 to 80°C for the period of 5 to 30 minutes. From a viewpoint of workability and so forth, it is preferable to soak the cured product 30 having been treated with the roughening treatment using the oxidant solution into the neutralization solution in the temperature range of 40 to 70°C for the period of 5 to 20 minutes.

From a viewpoint to enhance the adhesion with the plated layer, the arithmetic average roughness (Ra) of the cured product 30 after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured by using, for example, a non-contact type surface roughness meter.

### Process (5)

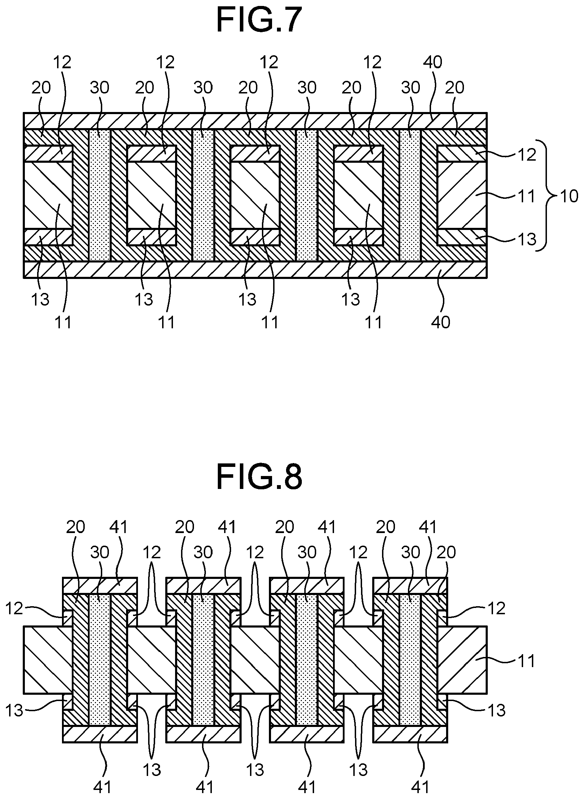

At the process (5), as illustrated in Fig. 7 as one example, a conductive layer 40 is formed on the polished surface of the cured product 30 and on the core substrate. Then, after the conductive layer 40 is formed, as illustrated in Fig. 8 as one example, by carrying out a treatment such as etching, a patterned conductive layer 41 may be formed by removing part of the conductive layer 40, the first metal layer 12, the second metal layer 13, and the plated layer 20. In Fig. 7, the conductive layer 40 is formed on both surfaces of the core substrate 10, but the conductive layer 40 may be formed on only one surface of the core substrate 10.

Illustrative examples of the method for forming the conductive layer 40 include a plating method, a sputtering method, and a vacuum evaporation method. Among them, the plating method is preferable. In a preferable embodiment, the surface of the cured product 30 (and the plated layer 20) is plated with a suitable method such as a semi-additive method or a full additive method and the patterned conductive layer 41 having an intended wiring pattern is formed. Illustrative examples of the material of the conductive layer 40 include a single metal such as gold, platinum, palladium, silver, copper, aluminum, cobalt, chromium, zinc, nickel, titanium, tungsten, iron, tin, and indium; and metal alloys of two or more metals selected from the group consisting of gold, platinum, palladium, silver, copper, aluminum, cobalt, chromium, zinc, nickel, titanium, tungsten, iron, tin, and indium. Among them, from viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is still more preferably usable.

Here, an example of the embodiment to form the patterned conductive layer 41 on the polished surface of the cured product 30 will be explained in detail. A plated seed layer is formed on the polished surface of the cured product 30 by electroless plating. Next, onto the plated seed layer thus formed, an electroplated layer is formed by electroplating; and as needed, an unnecessary plated seed layer is removed by a treatment such as etching, and thus, the conductive layer 40 having an intended wiring pattern can be formed. After the conductive layer 40 is formed, with an aim, among others, to enhance the peel strength of the conductive layer 40, an annealing treatment may be carried out, as needed. The annealing treatment may be carried out, for example, by heating the circuit substrate in the temperature range of 150 to 200°C for the period of 20 to 90 minutes.

From a viewpoint of thinning, the thickness of the patterned conductive layer is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

### Second Embodiment

The circuit substrate according to the second embodiment includes a cured product layer formed of a cured product of the resin composition. In the second embodiment, it is preferable to form the cured product layer by using a resin sheet. Hereinafter, the second embodiment with regard to the production method of a product substrate will be explained. Explanation overlapped with the first embodiment will be omitted as appropriate.

The circuit substrate according to the second embodiment is produced, for example, by the production method including the following processes (A) to (D):
(A) a process at which a resin sheet is laminated to an inner layer substrate in such a way that a resin composition layer may be bonded with the inner layer substrate to form a cured product layer;
(B) a process at which a drilling process to form a hole in the curd product layer is carried out;
(C) a process at which a surface of the cured product layer is subjected to a roughening treatment: and
(D) a process at which a conductive layer is formed on a polished surface of the cured product layer.

Hereinafter, in production of the circuit substrate, the processes (A) to (D) will be explained in detail.

### Process (A)

The process (A) is the process at which a resin sheet is laminated to an inner layer substrate in such a way that a resin composition layer may be bonded with the inner layer substrate to form a cured product layer. In one embodiment of the process (A), the resin sheet is laminated to the inner layer substrate in such a way that the resin composition layer may be bonded with the inner layer substrate, and then, the resin composition layer is thermally cured to form the cured product layer.

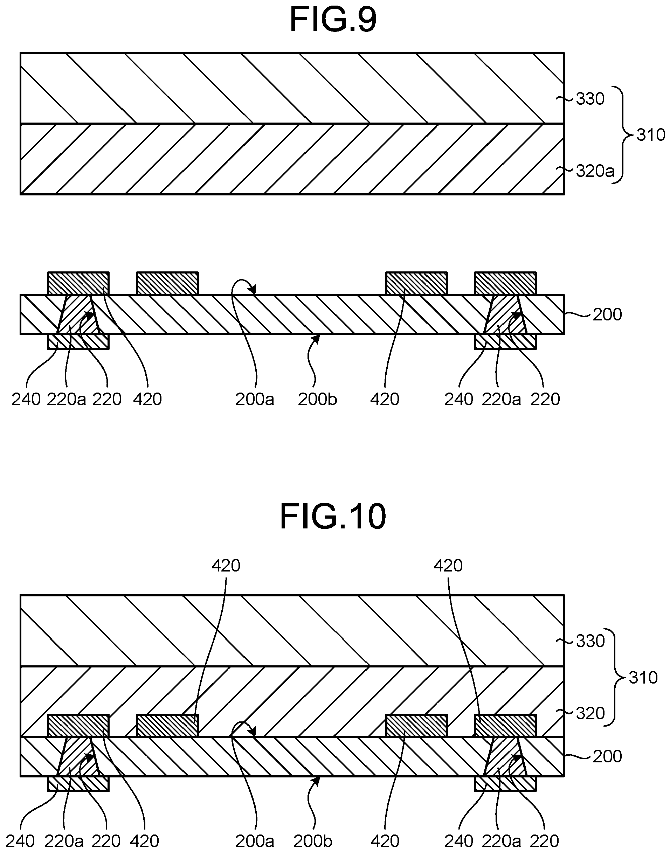

At the process (A), as illustrated in Fig. 9 as one example, a resin sheet 310 including a support 330 and a resin composition layer 320a that is formed on the support 330 is laminated to an inner layer substrate 200 in such a way that the resin composition layer 320a may be bonded with the inner layer substrate 200.

The inner layer substrate 200 is an insulation substrate. Illustrative examples of the material of the inner layer substrate 200 include insulation substrates such as a glass epoxy substrate, a metal substrate, a polyester substrate, a polyimide substrate, a BT resin substrate, and a thermosetting polyphenylene ether substrate. The inner layer substrate 200 may be an inner circuit substrate having a wiring or the like incorporated in the thickness thereof.

As illustrated in Fig. 9 as one example, the inner layer substrate 200 has a first conductive layer 420 formed on a first main surface 200a and an outside terminal 240 formed on a second main surface 200b. The first conductive layer 420 may include a plurality of wirings. In the example illustrated by the drawing, only a wiring that constitutes a coil-like conductive structural body 400 of an inductor element is illustrated. The outside terminal 240 is a terminal to electrically connect to an outside device or the like that is not illustrated in the drawing. The outside terminal 240 may be constructed as part of a conductive layer formed on the second main surface 200b.

Conductive materials capable of constructing the first conductive layer 420 and the outside terminal 240 are the same as the materials of the conductive layer that have been explained in the paragraphs of "Process (5)" in the first embodiment.

The first conductive layer 420 and the outside terminal 240 may be any of a monolayer structure or a multilayer structure in which two or more layers formed of single metal layers or alloy layers formed of different metals or alloys are laminated. Thicknesses of the first conductive layer 420 and the outside terminal 240 are the same as those of a second conductive layer 440 to be described later.

The line (L)/space (S) ratio of the first conductive layer 420 and the outside terminal 240 is not particularly restricted. From a viewpoint to reduce irregularity of the surface thereby obtaining the cured product layer that is excellent in the smoothness, the ratio is usually 900/900 µm or less, preferably 700/700 µm or less, more preferably 500/500 µm or less, and still more preferably 300/300 µm or less, while far still more preferably 200/200 µm or less. The lower limit of the line/space ratio is not particularly restricted; from a viewpoint to enhance an embedding property of the resin composition layer into the space, the ratio is preferably 1/1 µm or more.

The inner layer substrate 200 may have a plurality of through holes 220 that are formed so as to penetrate the inner layer substrate 200 from the first main surface 200a to the second main surface 200b. In the through hole 220, a through hole wiring 220a is formed. The through hole wiring 220a electrically connects the first conductive layer 420 with the outside terminal 240.

Bonding of the resin composition layer 320a with the inner layer substrate 200 may be carried out, for example, by hot-press bonding of the resin sheet 310 to the inner layer substrate 200 by pressing from the side of the support 330. Illustrative examples of the component for hot-press bonding of the resin sheet 310 to the inner layer substrate 200 (hereinafter, this component is also called "hot-pressing component") include a heated metal plate (stainless steel (SUS) mirror plate and the like) and a heated metal roll (SUS roll). At this time, it is preferable that the hot-pressing component is not pressed directly to the resin sheet 310 but is pressed via an elastic material such as a heat-resistant rubber so that the resin sheet 310 may well follow the surface irregularity of the inner layer substrate 200.

The temperature at the time of the hot-press bonding is preferably in the range of 80 to 160°C, and more preferably in the range of 90 to 140°C, while still more preferably in the range of 100 to 120°C. The pressure at the time of the hot-press bonding is preferably in the range of 0.098 to 1.77 MPa, while more preferably in the range of 0.29 to 1.47 MPa. The period at the time of the hot-press bonding is preferably in the range of 20 to 400 seconds, while more preferably in the range of 30 to 300 seconds. The bonding of the resin sheet with the inner layer substrate is carried out preferably under an evacuated condition with the pressure of 26.7 hPa or less.

Bonding of the resin composition layer 320a of the resin sheet 310 with the inner layer substrate 200 may be carried out by using a commercially available vacuum laminator. Illustrative examples of the commercially available vacuum laminator include a vacuum press type laminator manufactured by Meiki Co., Ltd. and a vacuum applicator manufactured by Nikko-Materials Co., Ltd.

After the bonding of the resin sheet 310 with the inner layer substrate 200, for example, the laminated resin sheet 310 may be flattened by pressing with the hot-pressing component from the side of the support 330 under a normal pressure (under an atmospheric pressure). The pressing conditions of the flattening treatment can be made the same as the hot-press bonding conditions in the beforementioned lamination. The flattening treatment may be carried out by using a commercially available laminator. The lamination and the flattening treatment may be carried out continuously by using the commercially available vacuum laminator described above.

After the resin sheet 310 is laminated to the inner layer substrate 200, the resin composition layer 320a is thermally cured to form a cured product layer. As illustrated in Fig. 10 as one example, the resin composition layer 320a that is bonded with the inner layer substrate 200 is thermally cured to form a first cured product layer 320.

Although conditions of the thermal curing of the resin composition layer 320a are different depending on the composition and kind of the resin composition, the curing temperature is preferably 120°C or higher, and more preferably 130°C or higher, while still more preferably 150°C or higher, and preferably 245°C or lower, and more preferably 220°C or lower, while still more preferably 200°C or lower. The curing period of the resin composition layer 320a is preferably 5 minutes or longer, and more preferably 10 minutes or longer, while still more preferably 15 minutes or longer, and preferably 120 minutes or shorter, and more preferably 110 minutes or shorter, while still more preferably 100 minutes or shorter.

The support 330 may be removed between after the thermal curing at the process (A) and the process (B), or after the process (B).

From a viewpoint to enhance the adhesion with the plated layer, the arithmetic average roughness (Ra) of the cured product layer before the roughening treatment is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured by using, for example, a non-contact type surface roughness meter.

At the process (A), the cured product layer may be formed by applying the resin composition, in place of the resin sheet, onto the inner layer substrate 200 by using a die coater or the like, which is then followed by thermal curing thereof.

### Process (B)

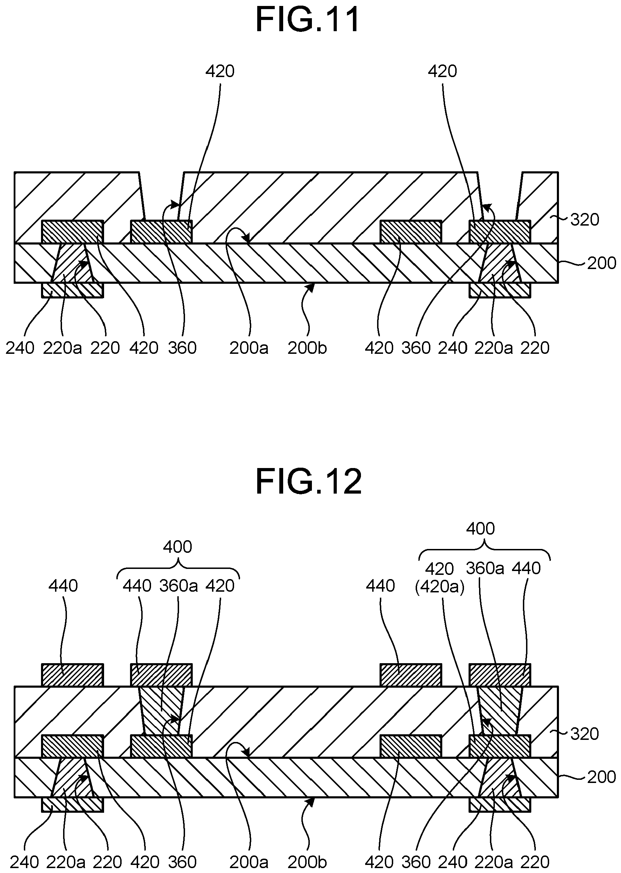

At the process (B), as illustrated in Fig. 11 as one example, a via hole 360 is formed by making a hole in the first cured product layer 320. The via hole 360 will be a channel to electrically connect a first conductive layer 420 with a second conductive layer 440 to be described later. Formation of the via hole 360 may be carried out by using a drill, a laser, a plasma, or the like in accordance with composition and the like of the resin composition used to form the cured product layer. The size and shape of the hole may be arbitrarily determined in accordance with a design of the printed wiring board.

### Process (C)

At the process (C), the surface of the cured product layer formed with the via hole is subjected to a roughening treatment. The roughening treatment at the process (C) is the same as that explained in the paragraphs of "Process (4)" in the first embodiment.

From a viewpoint to enhance the adhesion with a plating, the arithmetic average roughness (Ra) of the cured product layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by using a non-contact type surface roughness meter.

### Process (D)

At the process (D), as illustrated in Fig. 12 as one example, the second conductive layer 440 is formed on the first cured product layer 320.

The conductive materials capable of constituting the second conductive layer 440 are the same as those of the conductive layer explained in the paragraphs of "Process (5)" in the first embodiment.

From a viewpoint of thinning, the thickness of the second conductive layer 440 is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern can be formed. Note that, at this process, an inside-the-via-hole wiring 360a is concurrently formed in the via hole 360.

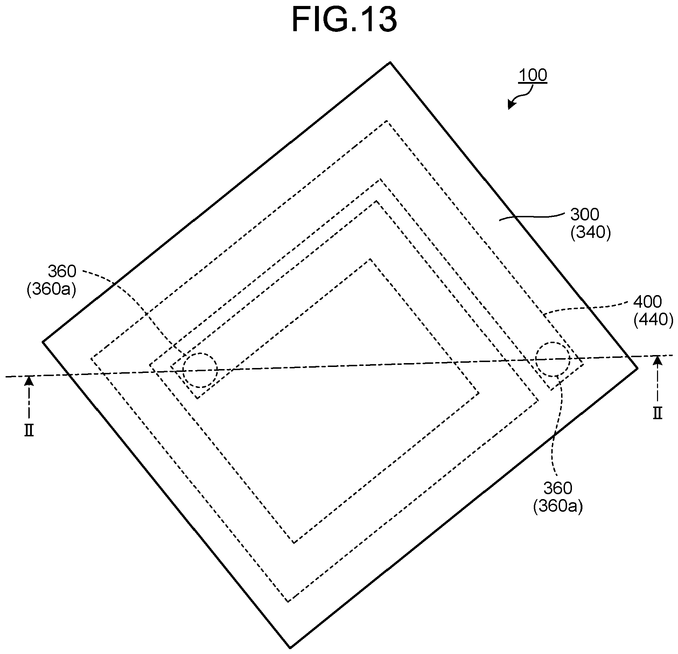

The first conductive layer 420 and the second conductive layer 440 may be formed, for example, spirally, as illustrated in Fig. 13 to Fig. 15 to be described later as one example. In one example, one end in the center side of the spiral wiring of the second conductive layer 440 is electrically connected through the inside-the-via-hole wiring 360a to one end in the center side of the spiral wiring of the first conductive layer 420. Other end in the circumferential side of the spiral wiring of the second conductive layer 440 is electrically connected through the inside-the-via-hole wiring 360a to a land 420a of the first conductive layer 42. Therefore, the other end in the circumferential side of the spiral wiring of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring that is part of the first conductive layer 420, the spiral wiring that is part of the second conductive layer 440, and the inside-the-via-hole wiring 360a that electrically connects between the spiral wiring of the first conductive layer 420 and the spiral wiring of the second conductive layer 440.

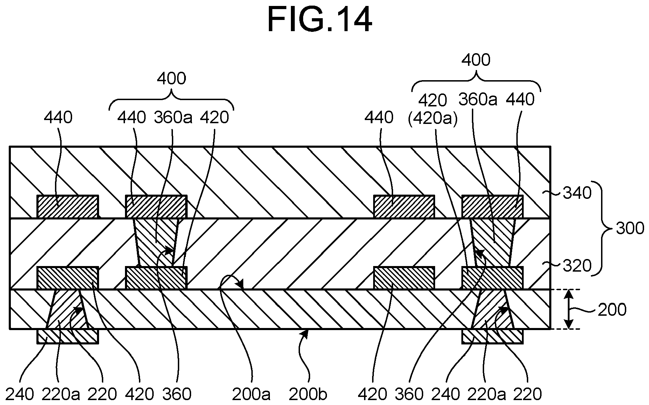

After the process (D), a process to further form a cured product layer on the conductive layer may be carried out. Specifically, as illustrated in Fig. 14 as one example, a second cured product layer 340 is formed on the first cured product layer 320 that has the second conductive layer 440 and the inside-the-via-hole wiring 360a formed therein. The second cured product layer may be formed with the same process as the process that has already been explained.

### Inductor Substrate

The inductor substrate includes the circuit substrate of the present invention. When the inductor substrate includes the circuit substrate obtained by the production method of the circuit substrate according to the first embodiment, the inductor substrate has an inductor pattern that is formed by a conductor at least in part around the cured product of the resin composition. The inductor substrate like this may be, for example, the one that is described in Japanese Patent Application Laid-open No. 2016-197624.

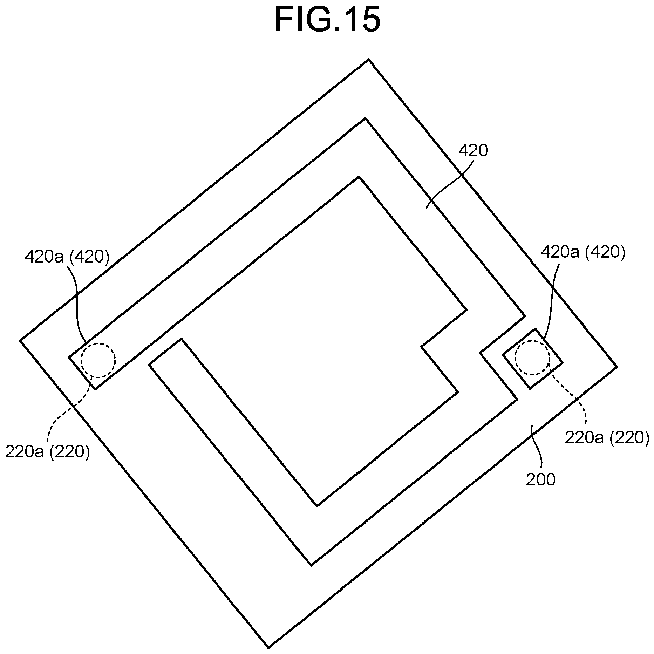

When the inductor substrate includes the circuit substrate obtained by the production method of the circuit substrate according to the second embodiment, the inductor substrate has a cured product layer and a conductive structural body having at least part thereof been embedded into the cured product layer. The inductor substrate includes this conductive structural body and an inductor element that is extendedly present in a thickness direction of the cured product layer and is composed of part of the cured product layer surrounded with the conductive structural body. Note that, Fig. 13 is a schematic plane view from one direction in a thickness direction of the inductor substrate, which includes the inductor element therein. Fig. 14 is a schematic plane view illustrating a cut end face of the inductor substrate that is cut at the place indicated by the II-II one dot chain line illustrated in Fig. 13. Fig. 15 is a schematic plane view to explain a composition of the first conductive layer in the inductor substrate.

As illustrated in Fig. 13 and Fig. 14 as one example, a circuit substrate 100 has a plurality of the cured product layers (the first cured product layer 320 and the second cured product layer 340) and a plurality of the conductive layers (the first conductive layer 420 and the second conductive layer 440). Namely, this is a build-up wiring board having a build-up cured product layer and a build-up conductive layer. Also, the inductor substrate 100 has an inner substrate 200.

From Fig. 14, the first cured product layer 320 and the second cured product layer 340 constitute a magnetic member 300, which can be regarded as an integrated cured product layer of these cured product layers. Therefore, the coil-like conductive structural body 400 is formed such that at least part thereof may be embedded into the magnetic member 300. Namely, in the inductor substrate 100 according to this embodiment, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in Fig. 15 as one example, the first conductive layer 420 includes the spiral wiring to constitute the coil-like conductive structure 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, outline of the entire spiral wiring of the first conductive layer 420 is substantially in a square shape and has a shape that the wiring is whirled in the anticlockwise direction from a center side to an outer side.

Similarly, the second conductive layer 440 is formed on the first cured product layer 320. The second conductive layer 440 includes the spiral wiring to constitute the coil-like conductive structural body 400. In Fig. 13 or Fig. 14, the spiral wiring includes a linear portion and a bent portion that is bent at a right angle to the linear portion. In Fig. 13 or Fig. 14, outline of the entire spiral wiring of the second conductive layer 44 is substantially in a square shape and has a shape that the wiring is whirled clockwise from a center side to an outer side.

The inductor substrate can be used as the wiring board to mount an electronic part such as a semiconductor chip, and can also be used as a (multi-layered) printed wiring board that uses this wiring board as the inner substrate. In addition, this can be used as a chip inductor part obtained by dicing the wiring board, and can also be used as a printed wiring board that is surface-mounted with the chip inductor part.

In addition, by using this wiring board, semiconductor devices with various embodiments may be produced. The semiconductor device having the wiring board can be suitably used in electric products (for example, a computer, a mobile phone, a digital camera, and a television), vehicles (for example, a motor bike, an automobile, a train, a marine ship, and an airplane), and so forth.

### EXAMPLES

Hereinafter, the present invention will be specifically explained, but the present invention is not limited to these Examples. Note that, in the description below, "%" that describes quantity means "% by mass" unless otherwise specifically mentioned. The temperature condition is at room temperature (23°C) unless the temperature is specified.

### Example 1

To the mixture of 30 parts by mass of Nano Soft Magnetic Powder a ("M001"; Mn type ferrite; average particle diameter of 0.15 µm; manufactured by Powdertech Co., Ltd.) and 70 parts by mass of Micro Soft Magnetic Powder a ("AW08PF3F"; FeSiCr type alloy (amorphous); average particle diameter of 3 µm; manufactured by Epson Atmix Corp.) were added 3 parts by mass of Liquid Epoxy Resin a ("ZX-1059"; a mixture of bisphenol A type epoxy resin and bisphenol F type epoxy resin; manufactured by Nippon Steel Chemical & Materials Co., Ltd.), 3 parts by mass of Liquid Epoxy Resin b ("EP-4088S"; glycidyl ether type aliphatic epoxy resin; manufactured by ADEKA Corp.), 1 part by mass of Liquid Epoxy Resin c ("630"; glycidyl ether type aromatic epoxy resin; manufactured by Mitsubishi Chemical Corp.), and 1 part by mass of an epoxy curing accelerator ("2MZA-PW"; imidazole type curing accelerator; manufactured by Shikoku Chemicals Corp.); and the resulting mixture was uniformly dispersed by using a high-speed rotation mixer to obtain a resin composition.

### Example 2

A resin composition was prepared in the same way as Example 1 except that 70 parts by mass of Micro Soft Magnetic Powder b (Fe-50%Ni alloy; average particle diameter of 3 µm; manufactured by DOWA Electronics Materials Co., Ltd.) was used in place of 70 parts by mass of Micro Soft Magnetic Powder a ("AW08PF3F"; manufactured by Epson Atmix Corp.).

### Example 3

A resin composition was prepared in the same way as Example 1 except that 70 parts by mass of Micro Soft Magnetic Powder c ("MZ05"; MnZn type ferrite; average particle diameter of 3 µm; manufactured by Powdertech Co., Ltd.) was used in place of 70 parts by mass of Micro Soft Magnetic Powder a ("AW08PF3F"; manufactured by Epson Atmix Corp.).

### Example 4

A resin composition was prepared in the same way as Example 1 except that the use amount of Nano Soft Magnetic Powder a ("M001"; manufactured by Powdertech Co., Ltd.) was changed from 30 parts by mass to 5 parts by mass and that the use amount of Micro Soft Magnetic Powder a ("AW08PF3F"; manufactured by Epson Atmix Corp.) was changed from 70 parts by mass to 95 parts by mass.

### Example 5

A resin composition was prepared in the same way as Example 1 except that the use amount of Nano Soft Magnetic Powder a ("M001"; manufactured by Powdertech Co., Ltd.) was changed from 30 parts by mass to 40 parts by mass and that the use amount of Micro Soft Magnetic Powder a ("AW08PF3F"; manufactured by Epson Atmix Corp.) was changed from 70 parts by mass to 60 parts by mass.

### Example 6

A resin composition was prepared in the same way as Example 1 except that 30 parts by mass of Nano Soft Magnetic Powder b ("MZ001"; MnZn type ferrite; average particle diameter of 0.15 µm; manufactured by Powdertech Co., Ltd.) was used in place of 30 parts by mass of Nano Soft Magnetic Powder a ("M001"; manufactured by Powdertech Co., Ltd.).

### Example 7

A resin composition was prepared in the same way as Example 1 except that 30 parts by mass of Nano Soft Magnetic Powder c ("NZ001"; NiZn type ferrite; average particle diameter of 0.15 µm; manufactured by Powdertech Co., Ltd.) was used in place of 30 parts by mass of Nano Soft Magnetic Powder a ("M001"; manufactured by Powdertech Co., Ltd.).

### Example 8

A resin composition was prepared in the same way as Example 1 except that 30 parts by mass of Nano Soft Magnetic Powder d ("E001"; MnMgSr type ferrite; average particle diameter of 0.15 µm; manufactured by Powdertech Co., Ltd.) was used in place of 30 parts by mass of Nano Soft Magnetic Powder a ("M001"; manufactured by Powdertech Co., Ltd.).

### Comparative Example 1

A resin composition was prepared in the same way as Example 1 except that Nano Soft Magnetic Powder a ("M001"; manufactured by Powdertech Co., Ltd.) was not used and that the use amount of Micro Soft Magnetic Powder a ("AW08PF3F"; manufactured by Epson Atmix Corp.) was changed from 70 parts by mass to 100 parts by mass.

### Comparative Example 2

A resin composition was prepared in the same way as Example 1 except that Nano Soft Magnetic Powder a ("M001"; manufactured by Powdertech Co., Ltd.) was not used and that 100 parts by mass of Micro Soft Magnetic Powder b (Fe-50%Ni alloy; average particle diameter of 3 µm; manufactured by DOWA Electronics Materials Co., Ltd.) was used in place of 70 parts by mass of Micro Soft Magnetic Powder a ("AW08PF3F"; manufactured by Epson Atmix Corp.).

### Comparative Example 3

A resin composition was prepared in the same way as Example 1 except that Nano Soft Magnetic Powder a ("M001"; manufactured by Powdertech Co., Ltd.) was not used and that 100 parts by mass of Micro Soft Magnetic Powder c ("MZ05"; manufactured by Powdertech Co., Ltd.) was used in place of 70 parts by mass of Micro Soft Magnetic Powder a ("AW08PF3F"; manufactured by Epson Atmix Corp.).

### Comparative Example 4

A resin composition was prepared in the same way as Example 1 except that the use amount of Nano Soft Magnetic Powder a ("M001"; manufactured by Powdertech Co., Ltd.) was changed from 30 parts by mass to 2 parts by mass and that the use amount of Micro Soft Magnetic Powder a ("AW08PF3F"; manufactured by Epson Atmix Corp.) was changed from 70 parts by mass to 98 parts by mass.

### Comparative Example 5

A resin composition was prepared in the same way as Example 1 except that the use amount of Nano Soft Magnetic Powder a ("M001"; manufactured by Powdertech Co., Ltd.) was changed from 30 parts by mass to 50 parts by mass and that the use amount of Micro Soft Magnetic Powder a ("AW08PF3F"; manufactured by Epson Atmix Corp.) was changed from 70 parts by mass to 50 parts by mass.

### Comparative Example 6

A resin composition was prepared in the same way as Example 1 except that 30 parts by mass of Other Soft Magnetic Powder a ("AW08PF1F"; FeSi type alloy; average particle diameter of 1 µm; manufactured by Epson Atmix Corp.) was used in place of 30 parts by mass of Nano Soft Magnetic Powder a ("M001"; manufactured by Powdertech Co., Ltd.).

### Comparative Example 7

A resin composition was prepared in the same way as Example 1 except that 70 parts by mass of Micro Soft Magnetic Powder c ("MZ05"; MnZn type ferrite; average particle diameter of 3 µm; manufactured by Powdertech Co., Ltd.) was used in place of 70 parts by mass of Micro Soft Magnetic Powder a ("AW08PF3F"; manufactured by Epson Atmix Corp.), and that 30 parts by mass of Other Soft Magnetic Powder b ("MZ03S"; MnZn type ferrite; average particle diameter of 1 µm; manufactured by Powdertech Co., Ltd.) was used in place of 30 parts by mass of Nano Soft Magnetic Powder a ("M001"; manufactured by Powdertech Co., Ltd.).

### Test Example 1: Measurement of Relative Permeability

A polyethylene terephthalate (PET) film ("PET 501010"; thickness of 50 µm; manufactured by Lintec Corp.) that was treated with a silicone type releasing agent was prepared as a support. Each of the resin compositions obtained in Examples and Comparative Examples was uniformly applied onto the release-treated surface of the PET film by using a doctor blade in such a way that the thickness of the resin composition layer after dried might become 100 µm to obtain a resin sheet. The resin sheet thereby obtained was heated at 180°C for 90 minutes to thermally cure the resin composition layer; and then, the support was removed to obtain a cured product in a sheet form. The cured product thus obtained was cut to a toroidal type specimen having the outer diameter of 19 mm and the inner diameter of 9 mm; then, this was used as a sample for evaluation. The relative permeability (µ') of this evaluation sample was measured by using Keysight Technology ("16454A E4991B"; manufactured by Keysight Technologies, Inc.) at room temperature (23°C) with the measurement frequency of 100 MHz.

### Test Example 2: Measurement of Tensile Strength at Breaking Point

The cured product in the sheet-like form prepared in Test Example 1 was cut out to the #1 dumbbell shape to obtain a specimen. The tensile strength at a breaking point of the specimen at 23°C was obtained by the tensile strength measurement using the tensile tester "RTC-1250A" manufactured by Orientec Co., Ltd. The measurement was carried out in accordance with JIS K7127. The measurement was repeated 3 times; and the average value thereof is listed in the table.

The non-volatile components in the resin composition and the amounts thereof in Examples and Comparative Examples, and the measurement results of Test Examples are summarized in Table 1 below.

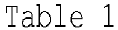

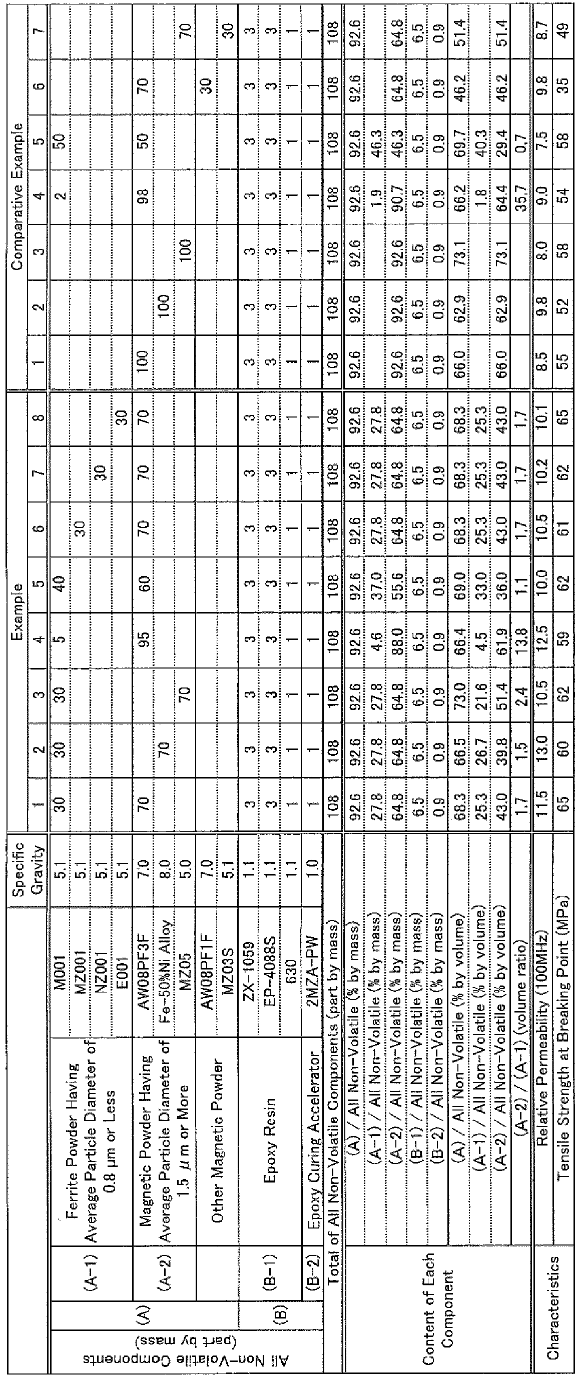

As discussed above, it became clear that the resin composition including (A) the magnetic powder and (B) the thermosetting resin, in which the (A) component includes (A-1) the ferrite powder having the average particle diameter of 0.8 µm or less and (A-2) the magnetic powder having the average particle diameter of 1.5 µm or more and the volume ratio of the (A-2) component to the (A-1) component ((A-2) component/(A-1) component) is in the range of 0.8 to 34.0, can give the magnetic material that is superior in the mechanical strength as well as the relative permeability.

## Claims

1. A resin composition including:
(A) a magnetic powder; and
(B) a thermosetting resin,
in which
the (A) component includes (A-1) a ferrite powder having an average particle diameter of 0.8 µm or less and (A-2) a magnetic powder having an average particle diameter of 1.5 µm or more, and
a volume ratio of the (A-2) component to the (A-1) component ((A-2) component/(A-1) component) is in a range of 0.8 to 34.0.

2. The resin composition according to claim 1, wherein the average particle diameter of the (A-2) component is 10.0 µm or less.

3. The resin composition according to claim 1 or 2, wherein the average particle diameter of the (A-2) component is 2.5 µm or more.

4. The resin composition according to any one of claims 1 to 3, wherein the average particle diameter of the (A-1) component is 0.1 µm or more.

5. The resin composition according to any one of claims 1 to 4, wherein the average particle diameter of the (A-1) component is 0.3 µm or less.

6. The resin composition according to any one of claims 1 to 5, wherein a ratio of the average particle diameter of the (A-2) component to the average particle diameter of the (A-1) component ((A-2) component/(A-1) component) is 10 or more.

7. The resin composition according to any one of claims 1 to 6, wherein the (A-1) component includes a ferrite powder including, in addition to Fe, at least one element selected from Mn, Zn, Mg, Sr, and Ni.

8. The resin composition according to any one of claims 1 to 7, wherein the (A-2) component includes a magnetic alloy powder.

9. The resin composition according to any one of claims 1 to 8, wherein a content of the (A) component is, based on 100% by volume of non-volatile components in the resin composition, 50% or more by volume.

10. The resin composition according to any one of claims 1 to 9, wherein a content of the (A) component is, based on 100% by volume of non-volatile components in the resin composition, 80% or less by volume.

11. The resin composition according to any one of claims 1 to 10, wherein a volume ratio of the (A-2) component to the (A-1) component ((A-2) component/(A-1) component) is 20.0 or less.

12. The resin composition according to claim 11, wherein a volume ratio of the (A-2) component to the (A-1) component ((A-2) component/(A-1) component) is 10.0 or less.

13. The resin composition according to any one of claims 1 to 12, wherein the (B) component includes (B-1) an epoxy resin.

14. The resin composition according to any one of claims 1 to 13, wherein a tensile strength at a breaking point of a cured product of the resin composition measured in accordance with JIS K7127 is 60 MPa or more.

15. The resin composition according to any one of claims 1 to 14, wherein a relative permeability (µ') of a cured product of the resin composition measured at 23°C with a measurement frequency of 100 MHz is 10.0 or more.

16. A cured product of the resin composition according to any one of claims 1 to 15.

17. A resin sheet including:
a support; and
a resin composition layer formed on the support and formed of the resin composition according to any one of claims 1 to 15.

18. A circuit substrate including:
a substrate having a through hole; and
a cured product of the resin composition according to any one of claims 1 to 15, the through hole being filled with the resin composition.

19. A circuit substrate including a cured product layer that is a cured product of the resin composition according to any one of claims 1 to 15.

20. An inductor substrate including the circuit substrate according to claim 18 or 19.
